# EUROPEAN PATENT APPLICATION

(11) **EP 4 687 403 A1**
(43) Date of publication of application: **04.02.2026**
(21) Application number: 25192586.3
(22) Date of filing: 29.07.2025
(51) Int. Cl.: H10K 39/34, H10K 59/131, H10K 65/00, H10K 59/35

(54) **DISPLAY DEVICE AND ELECTRONIC DEVICE**

(30) Priority: 31.07.2024 KR 20240102075
(71) Applicant: Samsung Display Co., Ltd., Yongin-si, Gyeonggi-do (KR)
(72) Inventor: Shin, Dong Hee, Yongin-si, Gyeonggi-do (KR); Son, Sunkwun, Yongin-si, Gyeonggi-do (KR); Cha, Nahyeon, Yongin-si, Gyeonggi-do (KR)
(74) Representative: Gulde & Partner

(57) **Abstract**

A display device includes a base layer, a circuit element layer, and a display element layer including a light emitting element and a light receiving element, wherein the circuit element layer includes pixel driving circuits connected to the light emitting element, sensor driving circuits connected to the light receiving element, a read-out line connected to the sensor driving circuits and extending in a first direction, a first data line connected to the pixel driving circuits and extending in the first direction, a first vertical connection line which is between the first data line and the read-out line in a second direction and extends in the first direction and to which a first DC signal is transmitted, and an insulating layer that covers the first vertical connection line and the first data line, and the first DC signal is a signal transmitted to the pixel driving circuits.

## Description

### BACKGROUND

Aspects of some embodiments of the present disclosure described herein relate to a display device and an electronic device including the same.

Electronic devices such as smartphones, digital cameras, laptop computers, navigation systems, and smart televisions that provide images to a user include display devices for displaying the images. The display device includes a display panel for generating images, an input device such as an input sensor, a camera for capturing external images, and various sensors.

The input sensor may be located on the display panel and sense a touch of the user. The sensors may include a fingerprint sensor, a proximity sensor, an illuminance sensor, and the like. Among the sensors, the fingerprint sensor may sense a fingerprint of the user provided on the display panel.

The above information disclosed in this Background section is only for enhancement of understanding of the background and therefore the information discussed in this Background section does not necessarily constitute prior art.

### SUMMARY

Aspects of some embodiments of the present disclosure described herein relate to a display device and an electronic device including the same, and for example, to a display device including a vertical connection line, and an electronic device including the same.

Aspects of some embodiments of the present disclosure include a display device in which optical sensors may be entirely arranged on a display surface.

According to some embodiments of the present disclosure, a display device includes a base layer on which a display area and a non-display area are defined, a circuit element layer on the base layer, and a display element layer on the circuit element layer and including a light emitting element and a light receiving element overlapping the display area, wherein the circuit element layer includes pixel driving circuits connected to the light emitting element, sensor driving circuits connected to the light receiving element, a read-out line connected to the sensor driving circuits and extending in a first direction, a first data line connected to the pixel driving circuits and extending in the first direction, a first vertical connection line between the first data line and the read-out line in a second direction intersecting the first direction and extends in the first direction and to which a first direct current (DC) signal is transmitted, and an insulating layer that covers the first vertical connection line and the first data line, and the first DC signal is a signal transmitted to the pixel driving circuits. The first DC signal may be an initialization voltage transmitted to the pixel driving circuits.

According to some embodiments, the circuit element layer may further include a first horizontal connection line which is electrically connected to the pixel driving circuits, extends in the second direction, and is connected to the first vertical connection line by a first through-hole passing through the insulating layer, and to which the first DC signal is transmitted.

According to some embodiments, the first vertical connection line and the first horizontal connection line may be arranged on different layers.

According to some embodiments, the first vertical connection line may be provided in plurality, the first horizontal connection line may be provided in plurality, and the plurality of first vertical connection lines and the plurality of first horizontal connection lines may have a mesh shape.

According to some embodiments, the read-out line may be between first vertical connection lines closest to each other among the plurality of first vertical connection lines.

According to some embodiments, the circuit element layer may further include a second data line connected to the pixel driving circuits, spaced apart from the first data line, and extending in the first direction, and a second vertical connection line between the second data line and the read-out line in the second direction and extends in the first direction and to which a second DC signal is transmitted. The second DC signal may be an initialization voltage transmitted to the pixel driving circuits. The second DC signal may have a potential different from that of the first DC signal.

According to some embodiments, the second DC signal may be transmitted to the sensor driving circuits.

According to some embodiments, the circuit element layer may further include a second horizontal connection line which extends in the second direction and is connected to the second vertical connection line by a second through-hole passing through the insulating layer and to which the second DC signal is transmitted.

According to some embodiments, the second vertical connection line and the second horizontal connection line may be arranged on different layers.

According to some embodiments, the second vertical connection line may be provided in plurality, the second horizontal connection line may be provided in plurality, and the plurality of second vertical connection lines and the plurality of second horizontal connection lines may have a mesh shape.

According to some embodiments, the read-out line may be between the first vertical connection line and the second vertical connection line.

According to some embodiments, each of the sensor driving circuits may be between the pixel driving circuits.

According to some embodiments, the first vertical connection line may overlap one of the sensor driving circuits.

According to some embodiments, the second vertical connection line may overlap the sensor driving circuits.

According to some embodiments, the first vertical connection line may be closer to a center of one of the sensor driving circuits than the first data line. The one of the sensor driving circuits may be the first sensor driving circuit.

According to some embodiments, the first vertical connection line may be electrically connected to the pixel driving circuits.

According to some embodiments of the present disclosure, an electronic device includes a display panel and a window on the display panel, wherein the display panel includes a base layer on which a display area and a non-display area are defined, a circuit element layer on the base layer, and a display element layer on the circuit element layer and including a light emitting element and a light receiving element overlapping the display area, wherein the circuit element layer includes pixel driving circuits connected to the light emitting element, sensor driving circuits connected to the light receiving element, a read-out line connected to the sensor driving circuits and extending in a first direction, a first data line and a second data line connected to the pixel driving circuits, extending in the first direction, and spaced apart from each other with one of the sensor driving circuits interposed therebetween in a second direction intersecting the first direction, a first vertical connection line and a second vertical connection line that are electrically connected to the pixel driving circuits or the sensor driving circuits, transmit a direct current (DC) signal, and are spaced apart from each other with the one sensor driving circuit interposed therebetween in the second direction, and an insulating layer that covers the first data line and the second data line and the first vertical connection line and the second vertical connection line, the first vertical connection line is closer to the read-out line than to the first data line, and the second vertical connection line is closer to the read-out line than to the second data line.

According to some embodiments, the circuit element layer may further include a first horizontal connection line electrically connected to the pixel driving circuits, extending in the second direction, and connected to the first vertical connection line by a first through-hole passing through the insulating layer, and a second horizontal connection line electrically connected to the pixel driving circuits, extending in the second direction, and connected to the second vertical connection line by a second through-hole passing through the insulating layer.

According to some embodiments, the first vertical connection line may transmit a first DC signal, and the second vertical connection line may transmit a second DC signal different from the first DC signal.

According to some embodiments, the first DC signal may be a signal transmitted to the pixel driving circuits, and the second DC signal may be a signal transmitted to the sensor driving circuits.

### BRIEF DESCRIPTION OF THE DRAWINGS

The above and other aspects and features of embodiments according to the present disclosure will become more apparent by describing in more detail aspects of some embodiments thereof with reference to the accompanying drawings.
FIG. 1 is a perspective view of a display device according to some embodiments of the present disclosure.
FIG. 2 is a view illustratively illustrating a cross section of the display device illustrated in FIG. 1.
FIG. 3 is a view illustratively illustrating a cross section of a display panel illustrated in FIG. 2.
FIG. 4 is a block diagram of the display device according to some embodiments of the present disclosure.
FIG. 5 is a view illustrating an equivalent circuit of any one of pixels illustrated in FIG. 4 and an optical sensor adjacent to the pixel.
FIG. 6 is a view illustratively illustrating a cross section of a light emitting element, a first transistor, a fourth transistor, and a sixth transistor of the pixel illustrated in FIG. 5.
FIGS. 7A and 7B are views illustratively illustrating cross sections of a light sensing element, a first sensing transistor, and a second sensing transistor of the optical sensor illustrated in FIG. 5.
FIG. 8 is a view illustrating an arrangement state of light emitting elements and light sensing elements arranged in a partial area of a display area illustrated in FIG. 4 on a plane (or in a plan view).
FIG. 9 is a schematic view illustrating a process of securing fingerprint information, which is biometric information, by the optical sensor illustrated in FIGS. 4, 7A, and 7B.
FIG. 10 is a plan view illustrating a data line, a vertical connection line, and a horizontal connection line according to some embodiments of the present disclosure.
FIG. 11 is an enlarged plan view of an area AA' of FIG. 10.
FIGS. 12 to 15 are plan views illustrating laminated structures of the data lines, the vertical connection lines, and the horizontal connection lines according to some embodiments of the present disclosure.
FIG. 16 is a plan view illustrating the data line, the vertical connection line, and the horizontal connection line according to some embodiments of the present disclosure.

### DETAILED DESCRIPTION

In the specification, the expression that a first component (or area, layer, part, portion, etc.) is "located on", "connected with" or "coupled to" a second component means that the first component is directly located on/connected with/coupled to the second component or means that a third component is interposed therebetween.

The same reference numerals refer to the same components. Further, in the drawings, the thickness, the ratio, and the dimension of components are exaggerated for effective description of technical contents. The expression "and/or" includes one or more combinations which associated components are capable of defining.

Although the terms "first", "second", etc. may be used to describe various components, the components should not be limited by the terms. The terms are only used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

Unless otherwise defined, all terms (including technical terms and scientific terms) used in the specification have the same meaning as commonly understood by those skilled in the art to which the present disclosure belongs. Furthermore, terms such as terms defined in the dictionaries commonly used should be interpreted as having a meaning consistent with the meaning in the context of the related technology and should not be interpreted in overly ideal or overly formal meanings unless explicitly defined herein.

Hereinafter, aspects of some embodiments of the present disclosure will be described in more detail with reference to the accompanying drawings.

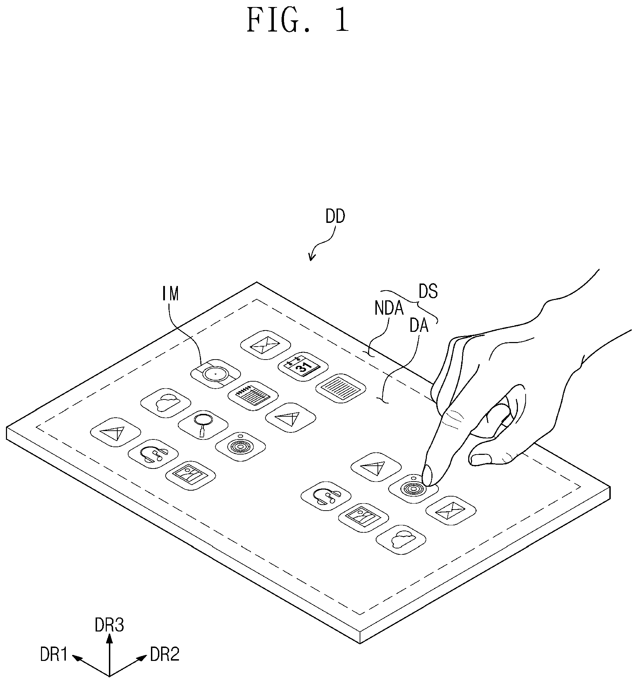

An electronic device may be activated according to an electrical signal and display images. The electronic device may include various embodiments, and for example, the electronic device may include large devices such as televisions and external billboards, and small and medium-sized devices such as monitors, mobile phones, tablet computers, navigation systems, and game machines. The embodiments of the electronic device are examples and embodiments according to the present disclosure are not limited to any one embodiment as long as they do not depart from the scope of embodiments according to the present disclosure. The electronic device comprises a display device DD (see FIG. 1). The electronic device further comprises a housing providing inner space accommodating the display device DD (see FIG.1).

FIG. 1 is a perspective view of a display device DD according to some embodiments of the present disclosure.

Referring to FIG. 1, the display device DD according to some embodiments of the present disclosure may have a rectangular shape having long sides extending in a first direction DR1 and short sides extending in a second direction DR2 intersecting the first direction DR1. However, embodiments according to the present disclosure are not limited thereto, and the display device DD may have various shapes such as a circular shape, an elliptical shape, a polygonal shape, or an irregular shape. Hereinafter, a direction perpendicular (or substantially perpendicular) to a plane defined by the first direction DR1 and the second direction DR2 is defined as a third direction DR3. In the specification, the meaning of the phrases "when viewed on a plane" or "in a plan view" is defined as a state of being viewed from the third direction DR3.

An upper surface of the display device DD may be defined as a display surface DS and may have the plane defined by the first direction DR1 and the second direction DR2. Images IM generated by the display device DD may be provided to a user through the display surface DS.

The display surface DS may include a display area DA and a non-display area NDA around (e.g., in a periphery or outside a footprint of) the display area DA. The display area DA displays images, and the non-display area NDA does not display images. The non-display area NDA may surround (e.g., in a periphery or outside a footprint of) the display area DA, but embodiments according to the present disclosure are not limited thereto, and the non-display area NDA may not be located on one side of the display area DA.

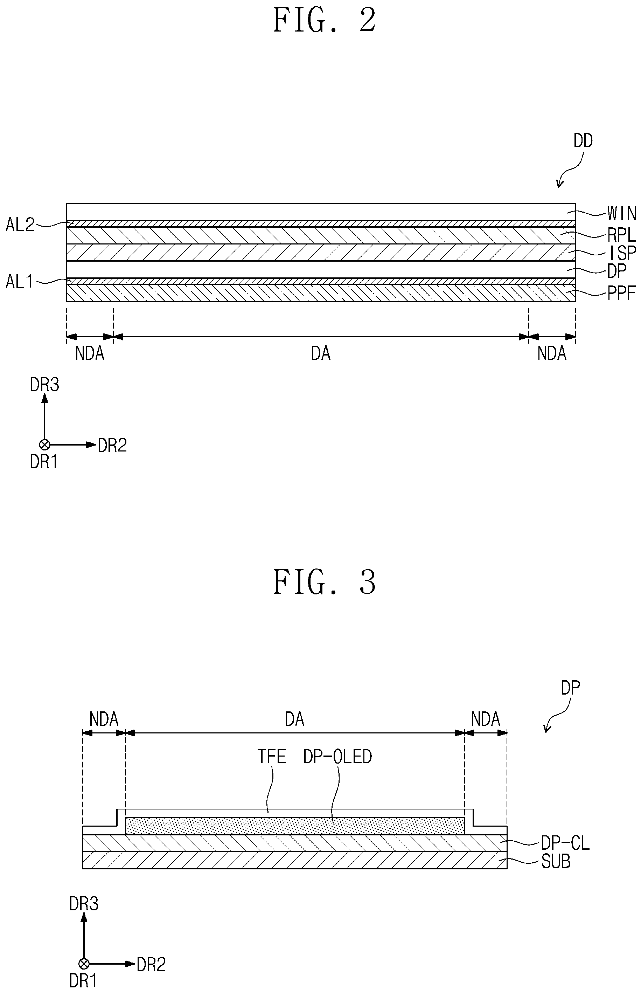

FIG. 2 illustratively illustrates a cross section of the display device DD illustrated in FIG. 1.

Referring to FIG. 2, the display device DD may include a display panel DP, an input sensor ISP, a reflection preventing layer RPL, a window WIN, a panel protecting film PPF, a first adhesive layer AL1, and a second adhesive layer AL2. According to some embodiments of the present disclosure, the input sensor ISP may be omitted.

The display panel DP according to some embodiments of the present disclosure may be a light emitting display panel, but embodiments according to the present disclosure are not particularly limited thereto. For example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot, a quantum rod, or the like. Hereinafter, the display panel DP is described as being an organic light emitting display panel.

The input sensor ISP may be located on the display panel DP. The input sensor ISP may include a plurality of sensors for sensing an external input in a capacitive manner. The input sensor ISP may be directly formed on the display panel DP when the display device DD is manufactured. However, embodiments according to the present disclosure are not limited thereto, and the input sensor ISP may be manufactured as a separate panel from the display panel DP and attached to the display panel DP using an adhesive layer.

The reflection preventing layer RPL may be located on the input sensor ISP. The reflection preventing layer RPL may be directly formed on the input sensor ISP when the display device DD is manufactured. The reflection preventing layer RPL may include a color filter and may further include a black mattress.

However, embodiments according to the present disclosure are not limited thereto, and the reflection preventing layer RPL may be manufactured as a separate panel and attached to the input sensor ISP by an adhesive layer. The reflection preventing layer RPL may include an optical film such as a polarizing film. The reflection preventing layer RPL may reduce a reflectance of an external light incident from an upper side of the display device DD toward the display panel DP. The external light may not be visually recognized by the user due to the reflection preventing layer RPL.

The window WIN may be located on the reflection preventing layer RPL. The window WIN may protect the display panel DP, the input sensor ISP, and the reflection preventing layer RPL from external scratches and impacts.

The panel protecting film PPF may be located under the display panel DP. The panel protecting film PPF may protect a lower portion of the display panel DP. The panel protecting film PPF may include a flexible plastic material such as polyethyleneterephthalate (PET).

FIG. 3 is a view illustratively illustrating a cross section of the display panel DP illustrated in FIG. 2.

Referring to FIG. 3, the display panel DP may include a base layer SUB, a circuit element layer DP-CL located on the base layer SUB, a display element layer DP-OLED located on the circuit element layer DP-CL, and a thin film encapsulation layer TFE located on the display element layer DP-OLED.

The base layer SUB may include the display area DA and the non-display area NDA around the display area DA, which is like the display device DD of FIG. 1. The base layer SUB may include glass or a flexible plastic material such as polyimide (PI).

The circuit element layer DP-CL may include a driving circuit for a light emitting element and a driving circuit for a light sensing element. The display element layer DP-OLED may include the light emitting element and the light sensing element. The thin film encapsulation layer TFE may be located on the circuit element layer DP-CL to cover the display element layer DP-OLED. The thin film encapsulation layer TFE may protect the pixels from moisture, oxygen, and external foreign substances.

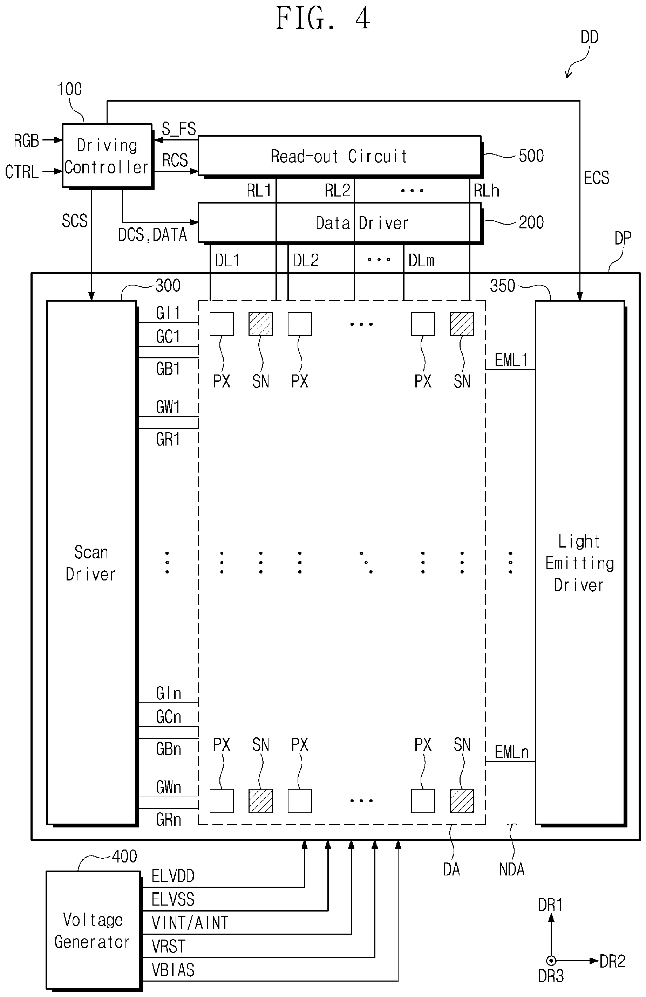

FIG. 4 is a block diagram of the display device DD according to some embodiments of the present disclosure.

Referring to FIG. 4, the display device DD includes the display panel DP, a driving controller 100, and a driving circuit for the display device. According to some embodiments of the present disclosure, the driving circuit of the display device includes a data driver 200, a scan driver 300, a light emitting driver 350, a voltage generator 400, and a read-out circuit 500. According to some embodiments of the present disclosure, the voltage generator 400 and the read-out circuit 500 together with the driving controller 100 may be implemented as one driving chip.

The display panel DP may include a plurality of pixels PX arranged in the display area DA and a plurality of optical sensors SN arranged in the display area DA. According to some embodiments of the present disclosure, each of the plurality of optical sensors SN may be located between two pixels PX adjacent to each other. However, an arrangement relationship between the optical sensors SN and the pixels PX is not limited thereto.

The display panel DP may include initialization scan lines GI1 to Gln, compensation scan lines GC1 to GCn, bias scan lines GB1 to GBn, writing scan lines GW1 to GWn, light emitting control lines EML1 to EMLn, reset scan lines GR1 to GRn, data lines DL1 to DLm, and read-out lines RL1 to RLh. The initialization scan lines GI1 to GIn, the compensation scan lines GC1 to GCn, the bias scan lines GB1 to GBn, the writing scan lines GW1 to GWn, the light emitting control lines EML1 to EMLn, and the reset scan lines GR1 to GRn extend in the second direction DR2. The data lines DL1 to DLm and the read-out lines RL1 to RLh extend in the first direction DR1.

The plurality of pixels PX are electrically connected to the initialization scan lines GI1 to GIn, the compensation scan lines GC1 to GCn, the writing scan lines GW1 to GWn, the bias scan lines GB1 to GBn, the light emitting control lines EML1 to EMLn, and the data lines DL1 to DLm. However, the number of signal lines connected to each of the pixels PX is not limited thereto and may be changed.

The plurality of optical sensors SN are electrically connected to the writing scan lines GW1 to GWn, the reset scan lines GR1 to GRn, and the read-out lines RL1 to RLh. The number of signal lines connected to the plurality of optical sensors SN is not limited thereto and may be changed.

The driving controller 100 receives an image signal RGB and a control signal CTRL. The driving controller 100 generates an image data signal DATA obtained by converting a data format of the image signal RGB such that the image data signal DATA satisfies an interface specification with the data driver 200. The driving controller 100 outputs a first control signal DCS, a second control signal SCS, a third control signal ECS, and a fourth control signal RCS.

The data driver 200 receives the first control signal DCS and the image data signal DATA from the driving controller 100. The data driver 200 converts the image data signal DATA into data signals and outputs the data signals to the plurality of data lines DL1 to DLm, which will be described below. The data signals are analog voltages corresponding to grayscale values of the image data signal DATA.

The scan driver 300 receives the second control signal SCS from the driving controller 100. The scan driver 300 outputs initialization scan signals to the initialization scan lines GI1 to GIn and outputs compensation scan signals to the compensation scan lines GC1 to GCn in response to the second control signal SCS. Further, the scan driver 300 may output writing scan signals to the writing scan lines GW1 to GWn and output black scan signals to the bias scan lines GB1 to GBn in response to the second control signal SCS. Further, the scan driver 300 may output reset scan signals to the reset scan lines GR1 to GRn in response to the second control signal SCS.

The light emitting driver 350 receives the third control signal ECS from the driving controller 100. The light emitting driver 350 may output light emitting control signals to the light emitting control lines EML1 to EMLn in response to the third control signal ECS. Alternatively, the scan driver 300 may be connected to the light emitting control lines EML1 to EMLn. In this case, the light emitting driver 350 may be omitted, and the scan driver 300 may output the light emitting control signals to the light emitting control lines EML1 to EMLn.

The read-out circuit 500 may receive the fourth control signal RCS from the driving controller 100. The read-out circuit 500 may receive sensing signals from the read-out lines RL1 to RLh in response to the fourth control signal RCS. The read-out circuit 500 may process the sensing signals received from the read-out lines RL1 to RLh and provide the processed sensing signals S_FS to the driving controller 100. The driving controller 100 may recognize biometric information based on the sensing signals S_FS.

The voltage generator 400 generates voltages required for operating the display panel DP. According to some embodiments, the voltage generator 400 may generate a first driving voltage ELVDD, a second driving voltage ELVSS having a lower level than the first driving voltage ELVDD, a first initialization voltage VINT, a second initialization voltage AINT, a reset voltage VRST, and a bias voltage VBIAS.

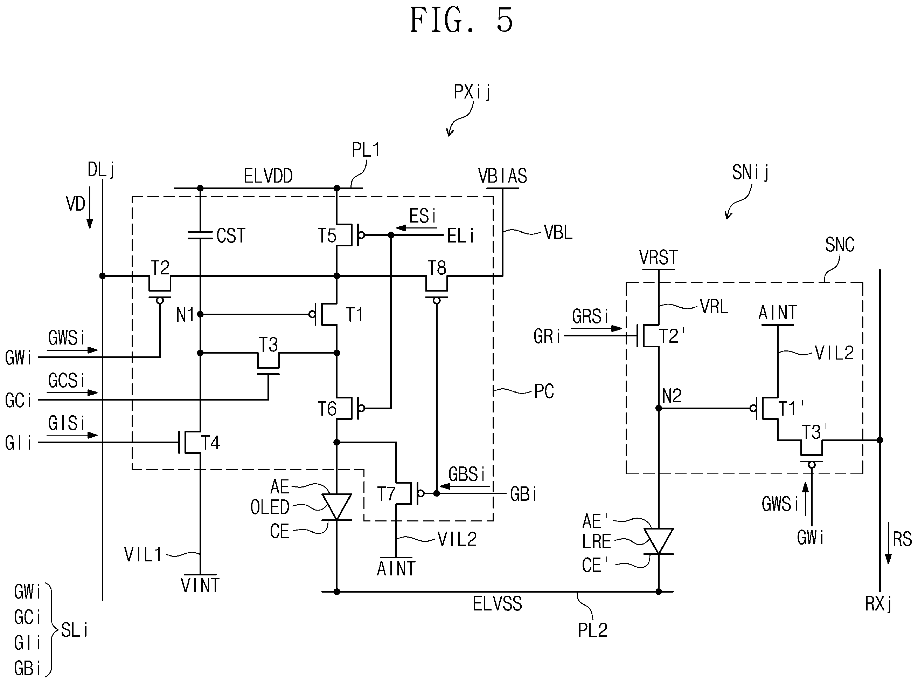

FIG. 5 is a view illustrating an equivalent circuit of any one pixel PXij among the pixels PX illustrated in FIG. 4 and an optical sensor SNij adjacent to the any one pixel PXij. Although FIG. 5 illustrates various components in a pixel and an optical sensor according to some embodiments, embodiments according to the present disclosure are not limited thereto, and according to various embodiments, the pixel and/or the optical sensor may include additional components or fewer components without departing from the scope of embodiments according to the present disclosure.

Illustratively, FIG. 5 illustrates the pixel PXij connected to an i^{th} scan lines SLi, an i^{th} light emitting line ELi, and a j^{th} data line DLj. Further, FIG. 5 illustratively illustrates the optical sensor SNij connected to an i^{th} reset scan line GRi and a j^{th} read-out line RXj. "i" and "j" are natural numbers. The i^{th} scan lines SLi may include an i^{th} initialization scan line Gli, an i^{th} compensation scan line GCi, an i^{th} bias scan line GBi, and an i^{th} writing scan line GWi.

Referring to FIG. 5, the pixel PXij may include a pixel driving circuit PC and a light emitting element OLED electrically connected to the pixel driving circuit PC. The light emitting element OLED may be turned on or off under control of the pixel driving circuit PC.

The pixel driving circuit PC may include a plurality of transistors T1 to T8 and a capacitor CST. The transistors T1 to T8 and the capacitor CST may control the amount of a current flowing through the light emitting element OLED. The light emitting element OLED may generate a light having brightness according to the amount of provided current.

The i^{th} writing scan line GWi may receive an i^{th} writing scan signal GWSi, and the i^{th} compensation scan line GCi may receive an i^{th} compensation scan signal GCSi. The i^{th} initialization scan line Gli may receive an i^{th} initialization scan signal GISi, and the i^{th} bias scan line GBi may receive an i^{th} bias scan signal GBSi. The i^{th} reset scan line GRi may receive an i^{th} reset scan signal GRSi. The i^{th} light emitting line ELi may receive an i^{th} light emitting signal ESi.

A first initialization line VIL1 may receive the first initialization voltage VINT, and a second initialization line VIL2 may receive the second initialization voltage AINT. A bias line VBL may receive the bias voltage VBIAS. A first power line PL1 may receive the first driving voltage ELVDD, and a second power line PL2 may receive the second driving voltage ELVSS. The light emitting element OLED may be connected to the second power line PL2. A reset line VRL may receive the reset voltage VRST.

Each of the transistors T1 to T8 may include a source (or a source terminal), a drain (or a drain terminal), and a gate (or a gate terminal). Hereinafter, in FIG. 5, for convenience, one of the source and the drain is defined as a first electrode, and the other thereof is defined as a second electrode. Further, the gate is defined as a gate electrode or a control electrode.

The transistors T1 to T8 may include the first to eighth transistors T1 to T8. The first, second, and fifth to eighth transistors T1, T2, and T5 to T8 may be p-type metal oxide semiconductor (PMOS) transistors. The third and fourth transistors T3 and T4 may be n-type metal oxide semiconductor (NMOS) transistors.

The first transistor T1 may be defined as a driving transistor, and the second transistor T2 may be defined as a switching transistor. The third transistor T3 may be defined as a compensation transistor. The fourth transistor T4 and the seventh transistor T7 may be defined as initialization transistors. The fifth transistor T5 and the sixth transistor T6 may be defined as light emitting control transistors. The eighth transistor T8 may be defined as a bias transistor.

The light emitting element OLED may include an organic light emitting diode. The light emitting element OLED may include a first electrode, a second electrode, and a light emitting layer located between the first electrode and the second electrode. According to some embodiments, for convenience of description, the first electrode is described as an anode AE, and the second electrode is described as a cathode CE. The anode AE may be electrically connected to the first power line PL1 through the sixth, first, and fifth transistors T6, T1, and T5. The cathode CE may be electrically connected to the second power line PL2.

The first transistor T1 may be located between the fifth transistor T5 and the sixth transistor T6 and connected to the fifth transistor T5 and the sixth transistor T6. The first transistor T1 may be connected to the first power line PL1 through the fifth transistor T5 and connected to the anode AE through the sixth transistor T6.

The first transistor T1 may include a first electrode connected to the first power line PL1 through the fifth transistor T5, a second electrode connected to the anode AE through the sixth transistor T6, and a gate electrode connected to a first node N1.

The first electrode of the first transistor T1 may be connected to the fifth transistor T5, and the second electrode of the first transistor T1 may be connected to the sixth transistor T6. The first transistor T1 may control the amount of current flowing through the light emitting element OLED according to a voltage of the first node N1 applied to the gate electrode of the first transistor T1.

The second transistor T2 may be located between the first transistor T1 and the j^{th} data line DLj and connected to the first transistor T1 and the j^{th} data line DLj. The second transistor T2 may include a first electrode connected to the j^{th} data line DLj, a second electrode connected to the first electrode of the first transistor T1, and a gate electrode connected to the i^{th} writing scan line GWi.

The second transistor T2 may be turned on by the i^{th} writing scan signal GWSi applied through the i^{th} writing scan line GWi and electrically connect the j^{th} data line DLj and the first electrode of the first transistor T1. The second transistor T2 may perform a switching operation of providing a data voltage VD applied through the j^{th} data line DLj to the first electrode of the first transistor T1.

The third transistor T3 may be connected to the second electrode of the first transistor T1 and the first node N1. The third transistor T3 may include a first electrode connected to the second electrode of the first transistor T1, a second electrode connected to the first node N1, and a gate electrode connected to the i^{th} compensation scan line GCi.

The third transistor T3 may be turned on by the i^{th} compensation scan signal GCSi applied through the i^{th} compensation scan line GCi and electrically connect the second electrode of the first transistor T1 and the gate electrode of the first transistor T1. When the third transistor T3 is turned on, the first transistor T1 and the third transistor T3 may be diode-connected to each other.

The fourth transistor T4 may be connected to the first node N1. The fourth transistor T4 may include a first electrode connected to the first node N1, a second electrode connected to the first initialization line VIL1, and a gate electrode connected to the i^{th} initialization scan line Gli. The fourth transistor T4 may be turned on by the i^{th} initialization scan signal GISi applied through the i^{th} initialization scan line Gli and provide the first initialization voltage VINT applied through the first initialization line VIL1 to the first node N1.

The fifth transistor T5 may include a first electrode connected to the first power line PL1, a second electrode connected to the first electrode of the first transistor T1, and a gate electrode connected to the i^{th} light emitting line ELi. The sixth transistor T6 may include a first electrode connected to the second electrode of the first transistor T1, a second electrode connected to the anode AE, and a gate electrode connected to the i^{th} light emitting line ELi.

The fifth transistor T5 and the sixth transistor T6 may be turned on by the i^{th} light emitting signal ESi applied through the i^{th} light emitting line ELi. The first driving voltage ELVDD is provided to the light emitting element OLED by the turned-on fifth transistor T5 and the turned-on sixth transistor T6, so that a driving current may flow in the light emitting element OLED. Thus, the light emitting element OLED may emit a light.

The seventh transistor T7 may include a first electrode connected to the anode AE, a second electrode connected to the second initialization line VIL2, and a gate electrode connected to the i^{th} bias scan line GBi. The seventh transistor T7 may be turned on by the i^{th} bias scan signal GBSi applied through the i^{th} bias scan line GBi and provide the second initialization voltage AINT received through the second initialization line VIL2 to the anode AE of the light emitting element OLED.

According to some embodiments of the present disclosure, the seventh transistor T7 may be omitted. According to some embodiments of the present disclosure, the second initialization voltage AINT may have a different level from the first initialization voltage VINT, but embodiments according to the present disclosure are not limited thereto, and the second initialization voltage AINT may have the same level as that first initialization voltage VINT.

The seventh transistor T7 may relatively improve black expression capability of the pixel PXij. When the seventh transistor T7 is turned on, a parasitic capacitor of the light emitting element OLED may be discharged. Thus, when black brightness is implemented, the light emitting element OLED does not emit a light due to a leakage current of the first transistor T1, and accordingly, the black expression capability may be relatively improved.

The capacitor CST may include a first electrode connected to the first power line PL1 and a second electrode connected to the first node N1. When the fifth transistor T5 and the sixth transistor T6 are turned on, the amount of current flowing through the first transistor T1 may be determined according to a voltage stored in the capacitor CST.

The eighth transistor T8 may include a first electrode connected to the bias line VBL, a second electrode connected to the first electrode of the first transistor T1, and a gate electrode connected to the i^{th} bias scan line GBi. According to some embodiments of the present disclosure, the eighth transistor T8 may be omitted.

The eighth transistor T8 may be turned on by the i^{th} bias scan signal GBSi and may provide the bias voltage VBIAS to the first electrode of the first transistor T1. As the bias voltage VBIAS is applied to the first transistor T1, movement of a hysteresis curve of the first transistor T1 may be suppressed.

The optical sensor SNij may include a sensor driving circuit SNC and a light sensing element LRE electrically connected to the sensor driving circuit SNC. The sensor driving circuit SNC may sense an operation of the light sensing element LRE.

The sensor driving circuit SNC may include a first sensing transistor T1', a second sensing transistor T2', and a third sensing transistor T3'. The first sensing transistor T1' and the third sensing transistor T3' may be PMOS transistors, and the second sensing transistor T2' may be an NMOS transistor.

The light sensing element LRE may be defined as a photo diode. The light sensing element LRE may convert light energy incident from the outside into electrical energy. The light sensing element LRE may include a first electrode, a second electrode, and a photoelectric converting layer located between the first electrode and the second electrode. According to some embodiments, for convenience of description, the first electrode is described as an anode AE', and the second electrode is described as a cathode CE'. The anode AE' may be connected to a second node N2, and the cathode CE' may be connected to the second power line PL2. To distinguish the anode AE and the cathode CE of the light emitting element OLED from the anode AE' and the cathode CE' of the light sensing element LRE, the anode AE and the cathode CE of the light emitting element OLED may be defined as a first electrode and a second electrode, and the anode AE' and the cathode CE' of the light sensing element LRE may be defined as a (1-1)^{th} electrode and a (2-1)^{th} electrode.

The first sensing transistor T1' may be connected to the light sensing element LRE, the second sensing transistor T2', and the third sensing transistor T3', The first sensing transistor T1' may include a first electrode that receives the second initialization voltage AINT, a gate electrode connected to the second node N2, and a second electrode connected to the third sensing transistor T3'. The first electrode of the first sensing transistor T1' may be connected to the second initialization line VIL2 to receive the second initialization voltage AINT. The second sensing transistor T2' may include a first electrode connected to the second node N2, a gate electrode connected to the i^{th} reset scan line GRi, and a second electrode connected to the reset line VRL. The third sensing transistor T3' may include a first electrode connected to the second electrode of the first sensing transistor T1', a gate electrode connected to the i^{th} writing scan line GWi, and a second electrode connected to the read-out line RXj. The third sensing transistor T3' may be turned on by the i^{th} writing scan signal GWSi received through the i^{th} writing scan line GWi.

The second sensing transistor T2' may be turned on by the i^{th} reset scan signal GRSi received through the i^{th} reset scan line GRi. The turned-on second sensing transistor T2' may receive the reset voltage VRST and provide the reset voltage VRST to the second node N2. The second node N2 may be reset by the reset voltage VRST.

The i^{th} writing scan signal GWSi may be applied to the gate electrode of the third sensing transistor T3' so that the third sensing transistor T3' may be turned on. The first sensing transistor T1' may be connected to the read-out line RXj by the turned-on third sensing transistor T3'.

The light sensing element LRE may receive a light and convert the light into an electrical signal, and in this case, a voltage of the second node N2 may be changed. When the first sensing transistor T1' is turned on, the second initialization voltage AINT provided to the first sensing transistor T1' may be controlled according to a change in a voltage of the second node N2 and may be provided to the read-out line RXj through the third sensing transistor T3'. Thus, a signal sensed by the light sensing element LRE may be output as a sensing signal RS through the read-out line RXj.

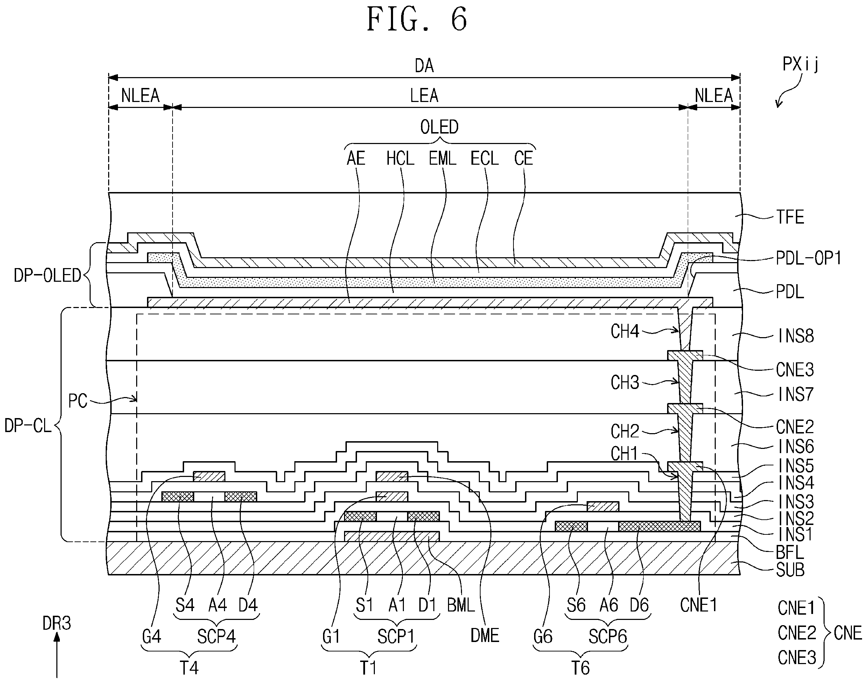

FIG. 6 is a view illustratively illustrating a cross section of the light emitting element OLED, the first transistor T1, the fourth transistor T4, and the sixth transistor T6 of the pixel PXij illustrated in FIG. 5.

FIG. 6 illustrates the first, fourth, and sixth transistors T1, T4, and T6 among the pixel driving circuit PC. Referring to FIG. 6, a shielding layer BML may be located on the base layer SUB. The shielding layer BML may overlap the first transistor T1. The shielding layer BML may include a metal and receive a constant voltage. When the constant voltage is applied to the shielding layer BML, a threshold voltage Vth of the first transistor T1 located on the shielding layer BML may be maintained without changing. Further, the shielding layer BML may shield a light incident to the first transistor T1 from a lower side of the shielding layer BML. For example, the shielding layer BML may include a reflective metal. According to some embodiments of the present disclosure, the shielding layer BML may be omitted.

A buffer layer BFL may be located on the base layer SUB, and the buffer layer BFL may include an inorganic layer. The buffer layer BFL may cover the shielding layer BML. A semiconductor layer SCP1 (or a semiconductor pattern area and hereinafter, described as a first semiconductor layer) of the first transistor T1 and a semiconductor layer SCP6 (or a semiconductor pattern area and hereinafter, described as a sixth semiconductor layer) of the sixth transistor T6 may be arranged on the buffer layer BFL. Hereinafter, the first semiconductor layer SCP1 and the sixth semiconductor layer SCP6 may include polysilicon. However, embodiments according to the present disclosure are not limited thereto, and the first semiconductor layer SCP1 and the sixth semiconductor layer SCP6 may include amorphous silicon.

The first semiconductor layer SCP1 and the sixth semiconductor layer SCP6 may be formed through the same process, and partial areas of the first semiconductor layer SCP1 and the sixth semiconductor layer SCP6 may be doped with an N-type dopant or a P-type dopant. The first semiconductor layer SCP1 and the sixth semiconductor layer SCP6 may include a high-doped area and a low-doped area. A conductivity of the high-doped area is greater than a conductivity of the low-doped area. The high-doped areas may correspond to source areas and drain areas of the first transistor T1 and the sixth transistor T6. The low-doped areas may correspond to active areas (or channels) of the first transistor T1 and the sixth transistor T6.

The high-doped area of the first semiconductor layer SCP1 may include a first source area S1 and a first drain area D1. The low-doped area of the first semiconductor layer SCP1 is defined as a first channel area A1 and is located between the first source area S1 and the first drain area D1. Similar to the first semiconductor layer SCP1, the sixth semiconductor layer SCP6 may include a sixth source area S6, a sixth channel area A6, and a sixth drain area D6.

On a cross section of FIG. 6, the first semiconductor layer SCP1 and the sixth semiconductor layer SCP6 may be spaced apart from each other. However, on a plane (or in a plan view), the first semiconductor layer SCP1 and the sixth semiconductor layer SCP6 may have an integrated shape. In other words, the first semiconductor layer SCP1 and the sixth semiconductor layer SCP6 may be different parts or different areas of one semiconductor pattern.

A first insulating layer INS1 that covers the first semiconductor layer SCP1 and the sixth semiconductor layer SCP6 may be located on the buffer layer BFL. Gate electrodes of the first transistor T1 and the sixth transistor T6 are arranged on the first insulating layer INS1. The gate electrodes of the first transistor T1 and the sixth transistor T6 may be formed through the same process. Hereinafter, the gate electrode of the first transistor T1 is defined as a first gate electrode G1, and the gate electrode of the sixth transistor T6 is defined as a sixth gate electrode G6. Like the first gate electrode G1, a metal layer formed on the first insulating layer INS1 may be defined as a first gate layer. The first gate layer may further include a plurality of patterns as well as the first gate electrode G1 and the sixth gate electrode G6.

A second insulating layer INS2 may be located on the first insulating layer INS1 to cover the first gate electrode G1 and the sixth gate electrode G6. A dummy electrode DME may be located on the second insulating layer INS2. The dummy electrode DME may be located on the first gate electrode G1, and may overlap the first gate electrode G1 when viewed on a plane (or in a plan view). The dummy electrode DME together with the first gate electrode G1 may form the capacitor CST. In other words, the first gate electrode G1 corresponds to one electrode of the capacitor CST (see FIG. 5), and the dummy electrode DME corresponds to the other one electrode of the capacitor CST (see FIG. 5). Like the dummy electrode DME, a metal layer formed on the second insulating layer INS2 may be defined as a second gate layer. The second gate layer may further include a plurality of patterns as well as the dummy electrode DME.

A third insulating layer INS3 may be located on the second insulating layer INS2 to cover the dummy electrode DME. A semiconductor layer SCP4 (or a semiconductor pattern area and hereinafter, described as a fourth semiconductor layer) of the fourth transistor T4 may be located on the third insulating layer INS3. The fourth semiconductor layer SCP4 may include an oxide semiconductor including a metal oxide. The oxide semiconductor may include a crystalline or amorphous oxide semiconductor.

The fourth semiconductor layer SCP4 may include a plurality of areas that are classified according to whether the metal oxide is reduced. An area (hereinafter, referred to as a reduced area) in which the metal oxide is reduced has conductivity higher than that of an area (hereinafter, a non-reduced area) in which the metal oxide is not reduced. The reduced areas may correspond to a source area and a drain area of the fourth transistor T4. The non-reduced area may correspond to an active area (or a channel) of the fourth transistor T4.

The reduced areas of the fourth semiconductor layer SCP4 may include a fourth source area S4 and a fourth drain area D4. A fourth channel area A4 may be located between the fourth source area S4 and the fourth drain area D4.

A fourth insulating layer INS4 may be located on the third insulating layer INS3 to cover the fourth semiconductor layer SCP4. A fourth gate electrode G4 of the fourth transistor T4 may be located on the fourth insulating layer INS4. Like the fourth gate electrode G4, a metal layer formed on the fourth insulating layer INS4 may be defined as a third gate layer. The third gate layer may further include a plurality of patterns as well as the fourth gate electrode G4.

A fifth insulating layer INS5 may be located on the fourth insulating layer INS4 to cover the fourth gate electrode G4. The buffer layer BFL and the first to fifth insulating layers INS1 to INS5 may include inorganic layers.

A connection electrode CNE may be located between the sixth transistor T6 and the light emitting element OLED. The connection electrode CNE may electrically connect the sixth transistor T6 and the light emitting element OLED. The connection electrode CNE may include a first connection electrode CNE1, a second connection electrode CNE2 located on the first connection electrode CNE1, and a third connection electrode CNE3 located on the second connection electrode CNE2.

The first connection electrode CNE1 may be located on the fifth insulating layer INS5 and may be connected to the sixth drain area D6 through a first contact hole CH1 defined by the first to fifth insulating layers INS1 to INS5. Like the first connection electrode CNE1, a metal layer formed on the fifth insulating layer INS5 may be defined as a first source/drain layer. The first source/drain layer may further include a plurality of patterns as well as the first connection electrode CNE1.

A sixth insulating layer INS6 may be located on the fifth insulating layer INS5 to cover the first connection electrode CNE1. The second connection electrode CNE2 may be located on the sixth insulating layer INS6. The second connection electrode CNE2 may be connected to the first connection electrode CNE1 through a second contact hole CH2 defined by the sixth insulating layer INS6. Like the second connection electrode CNE2, a metal layer formed on the sixth insulating layer INS6 may be defined as a second source/drain layer. The second source/drain layer may further include a plurality of patterns as well as the second connection electrode CNE2.

A seventh insulating layer INS7 may be located on the sixth insulating layer INS6 to cover the second connection electrode CNE2. The third connection electrode CNE3 may be located on the seventh insulating layer INS7. The third connection electrode CNE3 may be connected to the second connection electrode CNE2 through a third contact hole CH3 defined by the seventh insulating layer INS7. Like the third connection electrode CNE3, a metal layer formed on the seventh insulating layer INS7 may be defined as a third source/drain layer. The third source/drain layer may further include a plurality of patterns as well as the third connection electrode CNE3.

An eighth insulating layer INS8 may be located on the seventh insulating layer INS7 to cover the third connection electrode CNE3. The light emitting element OLED is located on the eighth insulating layer INS8. The sixth insulating layer INS6, the seventh insulating layer INS7, and the eighth insulating layer INS8 may include an inorganic layer or an organic layer. According to some embodiments, each of the sixth insulating layer INS6, the seventh insulating layer INS7, and the eighth insulating layer INS8 may include an organic layer.

The light emitting element OLED may include a first electrode AE, a second electrode CE, a hole control layer HCL, an electron control layer ECL, and a light emitting layer EML. The first electrode AE may be the anode AE illustrated in FIG. 5, and the second electrode CE may be the cathode CE illustrated in FIG. 5. The second electrode CE may be located on the first electrode AE, the hole control layer HCL and the electron control layer ECL may be arranged between the first electrode AE and the second electrode CE, and the light emitting layer EML may be located between the hole control layer HCL and the electron control layer ECL. The first electrode AE may be located on the eighth insulating layer INS8. The first electrode AE may be electrically connected to the third connection electrode CNE3 through a fourth contact hole CH4 defined in the eighth insulating layer INS8.

A pixel defining film PDL, through which a portion of the first electrode AE is exposed, may be located on the first electrode AE and the eighth insulating layer INS8. A first opening PDL-OP1, through which the portion of the first electrode AE is exposed, may be defined in the pixel defining film PDL. The first opening PDL-OP1 corresponds to a light emitting area LEA. The display area DA may include the light emitting area LEA corresponding to the first opening PDL-OP1 and a non-light emitting area NLEA adjacent to the light emitting area LEA.

The hole control layer HCL may be located on the first electrode AE and the pixel defining film PDL. The hole control layer HCL may be commonly located in the light emitting area LEA and the non-light emitting area NLEA. The hole control layer HCL may include a hole transport layer and a hole injection layer.

The light emitting layer EML may be located on the hole control layer HCL. The light emitting layer EML may be located in an area corresponding to the first opening PDL-OP1. The light emitting layer EML may include an organic material and/or an inorganic material. The light emitting layer EML may generate a light having any one of red, green, and blue.

The electron control layer ECL may be located on the light emitting layer EML and the hole control layer HCL. The electron control layer ECL may be commonly located in the light emitting area LEA and the non-light emitting area NLEA. The electron control layer ECL may include an electron transport layer and an electron injection layer.

The second electrode CE may be located on the electron control layer ECL. The second electrode CE may be commonly arranged in the pixels PX illustrated in FIG. 4. That is, the second electrode CE may be commonly arranged on the light emitting layers EML of the pixels PX.

A layer from the buffer layer BFL to the eighth insulating layer INS8 may be defined as the circuit element layer DP-CL. A layer, on which the light emitting element OLED is located, may be defined as the display element layer DP-OLED.

The thin film encapsulation layer TFE may be located on the light emitting element OLED. The thin film encapsulation layer TFE may include an inorganic layer, an organic layer, and an inorganic layer that are sequentially laminated. The inorganic layers may include inorganic materials and may protect the pixels from moisture/oxygen. The organic film may include an organic material and protect the light emitting element OLED from foreign substances such as dust particles.

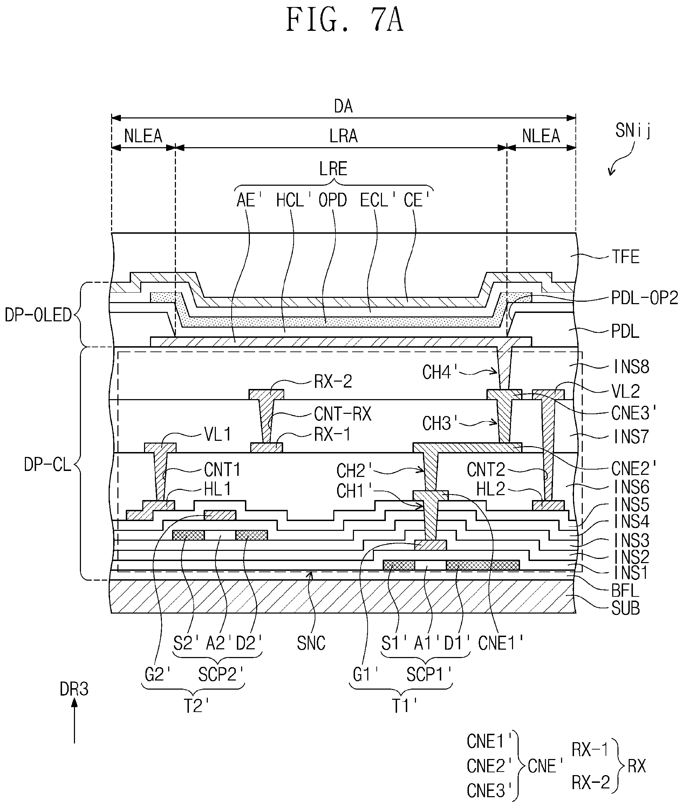

FIG. 7A is a view illustratively illustrating a cross section of the light sensing element LRE, the first sensing transistor T1', and the second sensing transistor T2' of the optical sensor SNij illustrated in FIG. 5. Hereinafter, a detailed description of the same configuration as that described in FIG. 6 refers to the description of FIG. 6.

Referring to FIG. 7A, a semiconductor layer SCP1' (hereinafter, referred to as a first sensing semiconductor layer) of the first sensing transistor T1' may be formed through the same process as the first semiconductor layer SCP1 of FIG. 6, and a semiconductor layer SCP2' (hereinafter, referred to as a second sensing semiconductor layer) of the second sensing transistor T2' may be formed through the same process as the fourth semiconductor layer SCP4 of FIG. 6. The first sensing semiconductor layer SCP1' may include a first source area S1', a first drain area D1', and a first channel area A1'. The second sensing semiconductor layer SCP2' may include a second source area S2', a second drain area D2', and a second channel area A2'.

The first sensing transistor T1' may include a first gate electrode G1'. The first gate electrode G1' may overlap the first channel area A1'. The first gate electrode G1' may be formed through the same process as the first gate electrode G1 of FIG. 6. Hereinafter, the first gate electrode G1' is defined as a first sensing gate electrode G1' to distinguish the first gate electrode G1' from the first gate electrode G1.

The second sensing transistor T2' may include a second gate electrode G2'. The second gate electrode G2' may overlap the second channel area A2'. The second gate electrode G2' may be formed through the same process as the fourth gate electrode G4 of FIG. 6. Hereinafter, the second gate electrode G2' is defined as a second sensing gate electrode G2'.

The laminated structure of the first sensing transistor T1' may be the same (or substantially the same) as the laminated structure of the first transistor T1 illustrated in FIG. 6. The laminated structure of the second sensing transistor T2' may be the same (or substantially the same) as the laminated structure of the fourth transistor T4 illustrated in FIG. 6. According to some embodiments, the laminated structure of the third sensing transistor T3' may be the same (or substantially the same) as the laminated structure of the first sensing transistor T1'.

A connection electrode CNE' may include a first connection electrode CNE1' (or a first sensing connection electrode), a second connection electrode CNE2' (or a second sensing connection electrode), and a third connection electrode CNE3' (or a third sensing connection electrode). The first connection electrode CNE1' may be located at the same layer as that of the first connection electrode CNE1 illustrated in FIG. 6 and may be connected to the first sensing gate electrode G1' of the first sensing transistor T1' through a first contact hole CH1'.

The second connection electrode CNE2' may be located at the same layer as that of the second connection electrode CNE2 illustrated in FIG. 6 and may be connected to the first connection electrode CNE1' through a second contact hole CH2' defined in the sixth insulating layer INS6. The third connection electrode CNE3' may be located at the same layer as that of the third connection electrode CNE3 illustrated in FIG. 6 and may be connected to the second connection electrode CNE2' through a third contact hole CH3'. The first electrode AE may be connected to the third connection electrode CNE3 through a fourth contact hole CH4' defined in the eighth insulating layer INS8.

A first vertical connection line VL1 may be located on the sixth insulating layer INS6. The first vertical connection line VL1 may be located at the same layer as that of the second connection electrode CNE2' and may be formed through the same process. A first horizontal connection line HL1 may be located on the fifth insulating layer INS5. The first horizontal connection line HL1 may be located at the same layer as that of the first connection electrode CNE1' and may be formed through the same process. The first vertical connection line VL1 may be connected to the first horizontal connection line HL1 through a first through-hole CNT1 passing through the sixth insulating layer INS6.

The first vertical connection line VL1 and the first horizontal connection line HL1 may be arranged on different layers. However, the layer, on which the first vertical connection line VL1 and the first horizontal connection line HL1 are arranged, is not limited to the illustration of the FIG. 7A and may be changed as needed.

For example, the first vertical connection line VL1 may be located on the seventh insulating layer INS7 and formed in the same process as the third connection electrode CNE3'. The first horizontal connection line HL1 may be located on the fourth insulating layer INS4 and may be formed in the same process as the second sensing gate electrode G2'. The first vertical connection line VL1 may be connected to the first horizontal connection line HL1 by a through-hole passing through the fifth insulating layer INS5, the sixth insulating layer INS6, and the seventh insulating layer INS7.

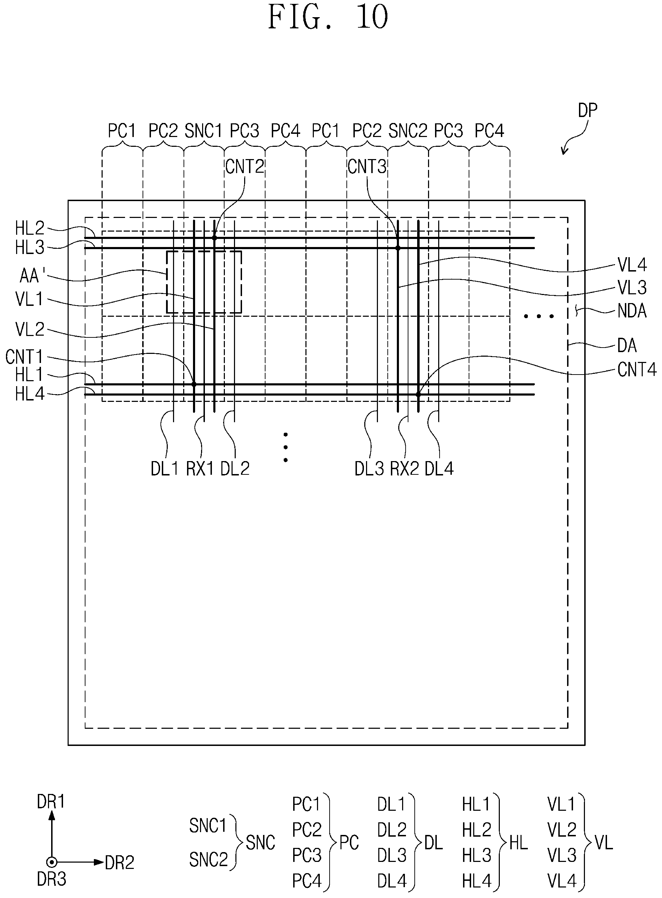

Here, the first vertical connection line VL1 and the first horizontal connection line HL1 may transmit a direct current (DC) signal transmitted to the pixel driving circuit PC (see FIG. 5) of FIG. 5. For example, the first vertical connection line VL1 and the first horizontal connection line HL1 may serve as the first initialization line VIL1 (see FIG. 5) that transmits the first initialization voltage VINT (see FIG. 5) of FIG. 5. This will be described below with reference to FIGS. 10 to 15.

The first vertical connection line VL1 and the first horizontal connection line HL1 are illustrated in similar shapes in FIG. 7A but may be connection lines extending in different directions. This will be described below with reference to FIG. 10.

The read-out line RX may include a first read-out portion RX-1 and a second read-out portion RX-2. The read-out line RX may extend in the same direction as the first vertical connection line VL1. The first read-out portion RX-1 may be located on the sixth insulating layer INS6 and may be formed through the same process as the second connection electrode CNE2'. The second read-out portion RX-2 may be located on the seventh insulating layer INS7 and may be formed through the same process as the third connection electrode CNE3'.

The first read-out portion RX-1 may be connected to the second read-out portion RX-2 by a through-hole CNT-RX passing through the seventh insulating layer INS7. FIG. 7A illustrates a cross section in which the read-out line RX includes two layers, which are connected to each other. However, the shape of the read-out line RX is not limited thereto. For example, the read-out line RX may have a shape of a single layer located on the sixth insulating layer INS6.

A second vertical connection line VL2 may be located on the seventh insulating layer INS7. The second vertical connection line VL2 may be located at the same layer as that of the third connection electrode CNE3' and may be formed through the same process. A second horizontal connection line HL2 may be located on the fifth insulating layer INS5. The second horizontal connection line HL2 may be located at the same layer as that of the first connection electrode CNE1' and may be formed through the same process. The second vertical connection line VL2 may be connected to the second horizontal connection line HL2 through a second through-hole CNT2 passing through the sixth insulating layer INS6 and the seventh insulating layer INS7.

The second vertical connection line VL2 and the second horizontal connection line HL2 may be located on different layers. However, the layer, on which the second vertical connection line VL2 and the second horizontal connection line HL2 are arranged, is not limited to the illustration of the FIG. 7A and may be changed as needed.

For example, the second vertical connection line VL2 may be located on the sixth insulating layer INS6 and formed in the same process as the second connection electrode CNE2'. The second horizontal connection line HL2 may be located on the fourth insulating layer INS4 and may be formed in the same process as the second sensing gate electrode G2'. The second vertical connection line VL2 may be connected to the second horizontal connection line HL2 by a through-hole passing through the fifth insulating layer INS5 and the sixth insulating layer INS6.

Here, the second vertical connection line VL2 and the second horizontal connection line HL2 may serve as the reset line VRL (see FIG. 5) that transmits the reset voltage VRST (see FIG. 5) of FIG. 5. This will be described below with reference to FIGS. 10 to 15.

The second vertical connection line VL2 and the second horizontal connection line HL2 are illustrated in similar shapes in FIG. 7A but may be connection lines extending in different directions. This will be described below with reference to FIG. 10.

The read-out line RX may be located between the first vertical connection line VL1 and the second vertical connection line VL2 on a plane (or in a plan view). The read-out line RX may be located closer to a center of a light receiving area LRA than the first vertical connection line VL1 and the second vertical connection line VL2.

Referring to FIG. 7A, the display area DA may include the light receiving area LRA corresponding to the optical sensor SNij and the non-light emitting area NLEA adjacent to the light receiving area LRA. The non-light emitting area NLEA may be the non-light emitting area NLEA illustrated in FIG. 6.

The light sensing element LRE may include a first electrode AE', a second electrode CE', a hole control layer HCL', an electron control layer ECL', and a photoelectric conversion layer OPD. The first electrode AE' may be the anode AE' illustrated in FIG. 5, and the second electrode CE' may be the cathode CE' illustrated in FIG. 5. A second opening PDL-OP2, through which a portion of the first electrode AE' is exposed, may be defined in the pixel defining film PDL. The light receiving area LRA corresponds to the second opening PDL-OP2.

The first electrode AE' is formed through the same process as the first electrode AE illustrated in FIG. 6. The second electrode CE', the hole control layer HCL', and the electron control layer ECL' may have an integral shape with the second electrode CE, the hole control layer HCL, and the electron control layer ECL illustrated in FIG. 6. The second electrode CE' of FIG. 7A and the second electrode CE of FIG. 6 may be different areas of a common electrode. The common electrode may be deposited to have an integral shape through an open mask. The hole control layer HCL' of FIG. 7A and the hole control layer HCL of FIG. 6 may also be different areas of a common hole control layer, and the electron control layer ECL' of FIG. 7A and the electron control layer ECL of FIG. 6 may also be different areas of a common electron control layer.

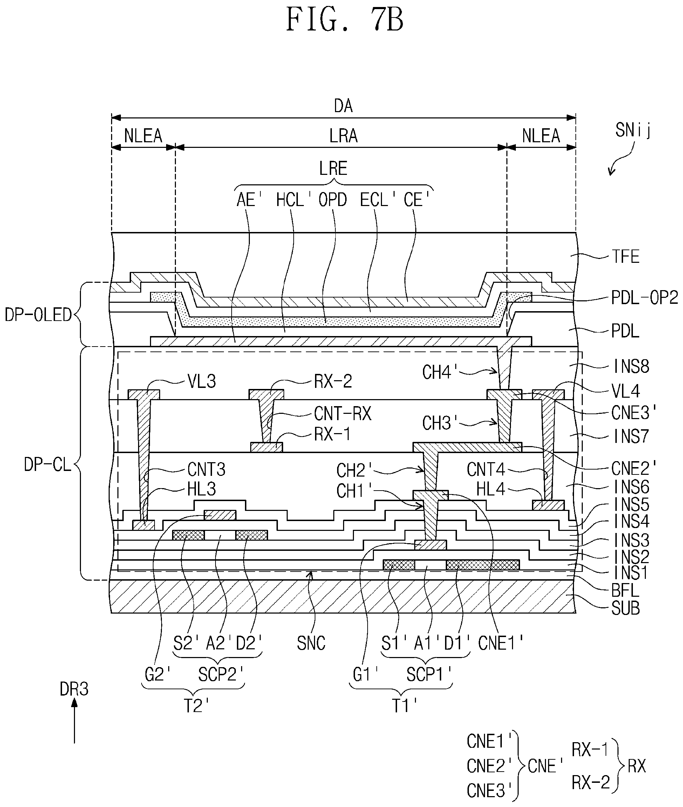

FIG. 7B is a view illustratively illustrating a cross section of the light sensing element LRE, the first sensing transistor T1', and the second sensing transistor T2' of the optical sensor SNij illustrated in FIG. 5. Hereinafter, a detailed description of the same configuration as the configuration described in FIGS. 6 and 7A will be made with reference to the description of FIGS. 6 and 7A. FIG. 7B is a view illustratively illustrating a cross section of the optical sensor SNij, which is different from that of FIG. 7A.

Referring to FIG. 7B, a third vertical connection line VL3 may be located on the seventh insulating layer INS7. The third vertical connection line VL3 may be located at the same layer as that of the third connection electrode CNE3' and may be formed through the same process. A third horizontal connection line HL3 may be located on the fourth insulating layer INS4. The third horizontal connection line HL3 may be located at the same layer as that of the second sensing gate electrode G2' and may be formed through the same process. The third vertical connection line VL3 may be connected to the third horizontal connection line HL3 through a third through-hole CNT3 passing through the fifth insulating layer INS5, the sixth insulating layer INS6, and the seventh insulating layer INS7.

The third vertical connection line VL3 and the third horizontal connection line HL3 may be arranged on different layers. However, the layer, on which the third vertical connection line VL3 and the third horizontal connection line HL3 are arranged, is not limited to the illustration of the FIG. 7B and may be changed as needed.

For example, the third vertical connection line VL3 may be located on the sixth insulating layer INS6 and formed in the same process as the second connection electrode CNE2'. The third horizontal connection line HL3 may be located on the fifth insulating layer INS5 and may be formed in the same process as the first sensing gate electrode CNE1'. The third vertical connection line VL3 may be connected to the third horizontal connection line HL3 by the through-hole passing through the sixth insulating layer INS6.

Here, the third vertical connection line VL3 and the third horizontal connection line HL3 may transmit the DC signal transmitted to the pixel driving circuit PC (see FIG. 5) of FIG. 5. For example, the third vertical connection line VL3 and the third horizontal connection line HL3 may serve as the second initialization line VIL2 (see FIG. 5) that transmits the second initialization voltage AINT (see FIG. 5) of FIG. 5. This will be described below with reference to FIGS. 10 to 15.

The third vertical connection line VL3 and the third horizontal connection line HL3 are illustrated in similar shapes in FIG. 7B but may be connection lines extending in different directions. This will be described below with reference to FIG. 10.

A fourth vertical connection line VL4 may be located on the seventh insulating layer INS7. The fourth vertical connection line VL4 may be located at the same layer as that of the third connection electrode CNE3' and may be formed through the same process. A fourth horizontal connection line HL4 may be located on the fifth insulating layer INS5. The fourth horizontal connection line HL4 may be located at the same layer as that of the first connection electrode CNE1' and may be formed through the same process. The fourth vertical connection line VL4 may be connected to the fourth horizontal connection line HL4 through a fourth through-hole CNT4 passing through the sixth insulating layer INS6 and the seventh insulating layer INS7.

The fourth vertical connection line VL4 and the fourth horizontal connection line HL4 may be arranged on different layers. However, the layer, on which the fourth vertical connection line VL4 and the fourth horizontal connection line HL4 are arranged, is not limited to the illustration of the FIG. 7B and may be changed as needed.

For example, the fourth vertical connection line VL4 may be located on the sixth insulating layer INS6 and formed in the same process as the second connection electrode CNE2'. The fourth horizontal connection line HL4 may be located on the fourth insulating layer INS4 and may be formed in the same process as the second sensing gate electrode G2'. The second vertical connection line VL2 may be connected to the second horizontal connection line HL2 by the through-hole passing through the fifth insulating layer INS5 and the sixth insulating layer INS6.

Here, the fourth vertical connection line VL4 and the fourth horizontal connection line HL4 may serve as the second power line PL2 (see FIG. 5) that transmits the second driving voltage ELVSS (see FIG. 5) of FIG. 5. This will be described below with reference to FIGS. 10 to 15.

The fourth vertical connection line VL4 and the fourth horizontal connection line HL4 are illustrated in similar shapes in FIG. 7B but may be connection lines extending in different directions. This will be described below with reference to FIG. 10.

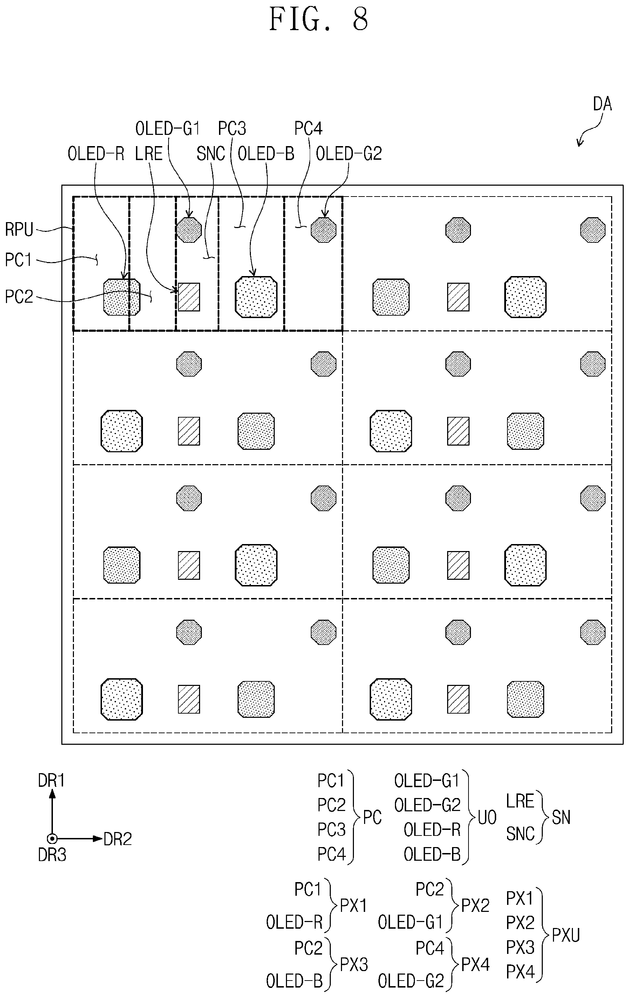

FIG. 8 is a view illustrating an arrangement state of the light emitting elements OLED and the light sensing elements LRE arranged in a partial area of the display area DA illustrated in FIG. 4 on a plane (or in a plan view).

FIG. 8 separately illustrates unit areas RPU repeatedly arranged in the display area DA. At least one pixel PX1, PX2, PX3, or PX4 and an optical sensor SN are arranged to correspond to the unit areas RPU. A combination of the pixels PX1, PX2, PX3, and PX4 corresponding to the unit areas RPU may be defined as a unit pixel PXU.

According to some embodiments, the unit pixel PXU includes the first pixel PX1, the second pixel PX2, the third pixel PX3, and the fourth pixel PX4. However, the number of pixels of the unit pixel PXU may be changed. The first pixel PX1 may include a first light emitting element OLED-R and a first pixel driving circuit PC1 electrically connected thereto, the second pixel PX2 may include a (2-1)^{th} light emitting element OLED-G1 and a second pixel driving circuit PC2 electrically connected thereto, the third pixel PX3 may include a third light emitting element OLED-B and a third pixel driving circuit PC3 electrically connected thereto, and the fourth pixel PX4 may include a (2-2)^{th} light emitting element OLED-G2 and a fourth pixel driving circuit PC4 electrically connected thereto.

FIG. 8 illustrates the one optical sensor SN corresponding to the unit pixel PXU, but as needed, a plurality of optical sensors SN corresponding to the unit pixel PXU may be provided. The optical sensor SN may include the light sensing element LRE and the sensor driving circuit SNC electrically connected thereto.

The first light emitting element OLED-R, the (2-1)^{th} light emitting element OLED-G1, the third light emitting element OLED-B, and the (2-2)^{th} light emitting element OLED-G2 of the unit pixel PXU and the light sensing elements LRE may be arranged to overlap each other in each of the unit areas RPU. Hereinafter, the light emitting elements OLED-R, OLED-G1, OLED-B, and OLED-G2 corresponding to the unit pixel PXU are defined as a unit light emitting element UO. The arrangement states of the unit light emitting element UO and the light sensing elements LRE of the unit areas RPU may be the same.

The first light emitting element OLED-R generates a first color light, for example, a red light, the (2-1)^{th} light emitting element OLED-G1 and the (2-2)^{th} light emitting element OLED-G2 generate second color lights, for example, green lights, and the third light emitting element OLED-B generates a third color light, for example, a blue light. A light emitting area of the third light emitting element OLED-B may be the largest, and a light emitting area of the (2-1)^{th} light emitting element OLED-G1 and the (2-2)^{th} light emitting element OLED-G2 may be the smallest.

According to some embodiments, the first light emitting element OLED-R and the third light emitting element OLED-B may be arranged on the same line, and the first light emitting element OLED-R and the third light emitting element OLED-B may be spaced apart from each other within the second direction DR2. The light sensing element LRE may be located between the first light emitting element OLED-R and the third light emitting element OLED-B within the second direction DR2. The (2-1)^{th} light emitting element OLED-G1 and the (2-2)^{th} light emitting element OLED-G2 are arranged on the same line but are arranged on a different line from that of the first light emitting element OLED-R and the third light emitting element OLED-B. The (2-1)^{th} light emitting element OLED-G1 may be located on one side of the light sensing element LRE within the first direction DR1. According to some embodiments, the (2-1)^{th} light emitting element OLED-G1 is located above the light sensing element LRE.

According to some embodiments of the present disclosure, the unit areas RPU may be classified based on arrangement of the pixel driving circuit PC and the sensor driving circuit SNC. The pixel driving circuit PC may include the first pixel driving circuit PC1, the second pixel driving circuit PC2, the third pixel driving circuit PC3, and the fourth pixel driving circuit PC4. Four the first pixel driving circuit PC1, the second pixel driving circuit PC2, the third pixel driving circuit PC3, and the fourth pixel driving circuit PC4 and the one sensor driving circuit SNC may be arranged in each of the unit areas RPU.

The first pixel driving circuit PC1, the second pixel driving circuit PC2, the third pixel driving circuit PC3, and the fourth pixel driving circuit PC4 may be arranged in the second direction DR2. The sensor driving circuit SNC may be located between two adjacent pixel driving circuits among the first pixel driving circuit PC1, the second pixel driving circuit PC2, the third pixel driving circuit PC3, and the fourth pixel driving circuit PC4. For example, the sensor driving circuit SNC may be located between the second pixel driving circuit PC2 and the third pixel driving circuit PC3 in the second direction DR2. However, the arrangement of the first pixel driving circuit PC1, the second pixel driving circuit PC2, the third pixel driving circuit PC3, the fourth pixel driving circuit PC4, and the sensor driving circuit SNC is not limited thereto.

Each of the first light emitting element OLED-R, the (2-1)^{th} light emitting element OLED-G1, the third light emitting element OLED-B, and the (2-2)^{th} light emitting element OLED-G2 may overlap or may not overlap a corresponding driving circuit among the first pixel driving circuit PC1, the second pixel driving circuit PC2, the third pixel driving circuit PC3, and the fourth pixel driving circuit PC4 on a plane (or in a plan view). For example, when the third connection electrode CNE3 of FIG. 6 has an extending shape on a plane (or in a plan view), the light emitting element OLED connected thereto may not overlap the corresponding second pixel driving circuit PC2, which is like the (2-1)^{th} light emitting element OLED-G1.

It has been described that all the first pixel driving circuit PC1, the second pixel driving circuit PC2, the third pixel driving circuit PC3, the fourth pixel driving circuit PC4, the first light emitting element OLED-R, the (2-1)^{th} light emitting element OLED-G1, the third light emitting element OLED-B, and the (2-2)^{th} light emitting element OLED-G2 are arranged inside the unit areas RPU, but embodiments according to the present disclosure are not limited thereto.

According to some embodiments of the present disclosure, any one of four the first pixel driving circuit PC1, the second pixel driving circuit PC2, the third pixel driving circuit PC3, and the fourth pixel driving circuit PC4 arranged in a first unit area of the unit areas RPU may be connected to any one of the first light emitting element OLED-R, the (2-1)^{th} light emitting element OLED-G1, the third light emitting element OLED-B, and the (2-2)^{th} light emitting element OLED-G2 arranged in a second unit area adjacent to the first unit area. For example, when the third connection electrode CNE3 of FIG. 6 further extends from the first unit area to the second unit area on a plane (or in a plan view), a driving circuit located in the first unit area and a light emitting element located in the second unit area may constitute one pixel.

Further, it has been described that both the sensor driving circuit SNC and the light sensing element LRE are arranged in the unit areas RPU, but embodiments according to the present disclosure are not limited thereto. For example, when the third connection electrode CNE3 of FIG. 7A further extends from the first unit area to the second unit area on a plane (or in a plan view), the driving circuit located in the first unit area and a light sensing element located in the second unit area may constitute one optical sensor.

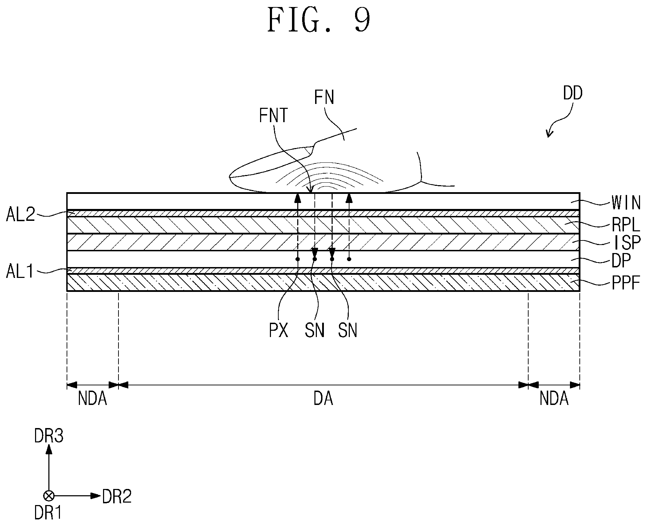

FIG. 9 is a schematic view illustrating a process of securing fingerprint information, which is biometric information, by the optical sensor SNij illustrated in FIGS. 4, 7A, and 7B.

Referring to FIG. 9, the display device DD may include a plurality of optical sensors SN. Each of the optical sensors SN may have the same configuration as the optical sensor SNij illustrated in FIGS. 5, 7A, and 7B. The optical sensors SN may sense a fingerprint FNT of a finger FN provided on the display panel DP. Lights generated by the light emitting elements OLED of the pixels PX may be provided to the fingerprint FNT and reflected by the fingerprint FNT. The fingerprint FNT is defined by a form of valleys and ridges, and optical reflectance rates of the valleys and the ridges are different from each other. The plurality of optical sensors SN receive lights reflected from the valleys or the ridges depending on positions thereof. Information on the fingerprint FNT may be obtained using information sensed by a plurality of optical sensors SN.

FIG. 10 is a plan view illustrating the data line DL, the vertical connection line VL, and the horizontal connection line HL according to some embodiments of the present disclosure. The vertical connection line VL may be a connection line extending in the first direction DR1 and transmitting a direct current signal, and the horizontal connection line may be a connection line extending in the second direction DR2 and transmitting a direct current signal.

Referring to FIG. 10, the vertical connection line VL may extend in the first direction DR1. The vertical connection line VL may be provided as a plurality of vertical connection lines VL, and the plurality of vertical connection lines VL may be arranged in the second direction DR2. Two closest vertical connection lines VL among the plurality of vertical connection lines VL may be spaced apart from each other in the second direction DR2 with one read-out line among the read-out lines RX-1 and RX-2 interposed therebetween.

The horizontal connection line HL may extend in the second direction DR2. The horizontal connection line HL may be provided as a plurality of horizontal connection lines HL, and the plurality of horizontal connection lines HL may be arranged in the first direction DR1. The vertical connection lines VL and the horizontal connection lines HL may be connected to each other to form a mesh shape.

The read-out line RX may be connected to the sensor driving circuit SNC and extend in the first direction DR1. The read-out line RX may overlap the sensor driving circuit SNC. The read-out line RX may not overlap the pixel driving circuit PC.

The read-out line RX may include the first read-out portion RX-1 and the second read-out portion RX-2. The first read-out portion RX-1 may overlap a first sensor driving circuit SNC1 and may extend in the first direction DR1. The second read-out portion RX-2 may overlap a second sensor driving circuit SNC2 and may extend in the first direction DR1. Here, the read-out line RX may be the read-out line RXj (see FIG. 5) of FIG. 5.

The data line DL may be connected to the pixel driving circuit PC and extend in the first direction DR1. The data line DL may include a first data line DL1, a second data line DL2, a third data line DL3, and a fourth data line DL4. The first data line DL1 and the third data line DL3 may overlap the second pixel driving circuit PC2, and the second data line DL2 and the fourth data line DL4 may overlap the third pixel driving circuit PC3. The first data line DL1, the second data line DL2, the third data line DL3, and the fourth data line DL4 may be spaced apart from each other and may be arranged in the second direction DR2. Here, the first data line DL1, the second data line DL2, the third data line DL3, and the fourth data line DL4 are illustratively illustrated as lines of the plurality of data lines DL, which are close to the sensor driving circuit SNC, and the number of data lines DL is not limited thereto.

Here, the data line DL may be the j^{th} data line DLj (see FIG. 5) of FIG. 5.

The vertical connection lines VL may include the first vertical connection line VL1, the second vertical connection line VL2, the third vertical connection line VL3, and the fourth vertical connection line VL4. The first vertical connection line VL1, the second vertical connection line VL2, the third vertical connection line VL3, and the fourth vertical connection line VL4 may be arranged in the second direction DR2. Two closest vertical connection lines among the first vertical connection line VL1, the second vertical connection line VL2, the third vertical connection line VL3, and the fourth vertical connection line VL4 may be spaced apart from each other in the second direction DR2 with one read-out line among the first read-out line RX-1 and the second read-out line RX-2 interposed therebetween.

The first vertical connection line VL1 may be located on a left side of the first read-out portion RX-1 and extend in the first direction DR1, and the second vertical connection line VL2 may be located on a right side of the first read-out portion RX-1 and extend in the first direction DR1. The first vertical connection line VL1 may overlap the first sensor driving circuit SNC1, and the second vertical connection line VL2 may overlap the first sensor driving circuit SNC1. The first read-out portion RX-1 may overlap the first sensor driving circuit SNC1.

The first vertical connection line VL1 may be located between the first data line DL1 and the first read-out portion RX-1 in the second direction DR2. The first vertical connection line VL1 may be located closer to the first read-out portion RX-1 than to the first data line DL1 on a plane (or in a plan view). A first DC signal may be transmitted to the first vertical connection line VL1.

Here, the first DC signal may be a signal transmitted to the pixel driving circuits PC. For example, the first DC signal may be one of the first initialization voltage VINT (see FIG. 5), the second initialization voltage AINT (see FIG. 5), and the second driving voltage ELVSS (see FIG. 5) of FIG. 5. The first DC signal may be transmitted to the pixel driving circuits PC through the first horizontal connection line HL1 connected to the first vertical connection line VL1.

The first vertical connection line VL1 may be electrically connected to the pixel driving circuits PC to transmit the first DC signal. Because the first DC signal transmitted to the pixel driving circuits PC is transmitted to the first vertical connection line VL1, a separate vertical wiring line may not be required in the pixel driving circuits PC. For example, when the first DC signal is the first initialization voltage VINT (see FIG. 5), a separate vertical wiring line for transmitting the first initialization voltage VINT (see FIG. 5) to the pixel driving circuits PC may not be required. Accordingly, even when a resolution of the display device DD (see FIG. 1) is increased, difficulty in integrating wiring lines may be reduced.

The first vertical connection line VL1 may be closer to a center of the first sensor driving circuit SNC1 than the first data line DL1. The first vertical connection line VL1 may be located between the first data line DL1 and the first read-out portion RX-1 in the second direction DR2 to prevent or reduce the first data line DL1 affecting the sensing signal RS (see FIG. 5) flowing through the first read-out portion RX-1. For example, even when the data voltage VD (see FIG. 5) is applied to the first data line DL1 as a pulse signal, the data voltage VD may be shielded by the first DC signal flowing through the first vertical connection line VL1 and thus may not affect the sensing signal RS (see FIG. 5) of the first read-out portion RX-1. In this way, the first vertical connection line VL1 may prevent or reduce coupling between the first data line DL1 connected to the pixel driving circuit PC and the first read-out portion RX-1 connected to the sensor driving circuit SNC.

The second vertical connection line VL2 may be located between the second data line DL2 and the first read-out portion RX-1 in the second direction DR2. The second vertical connection line VL2 may be electrically connected to the first sensor driving circuit SNC1 and may extend in the first direction DR1. The second vertical connection line VL2 may be located closer to the first read-out portion RX-1 than to the second data line DL2 on a plane (or in a plan view). A second DC signal may be transmitted to the second vertical connection line VL2. The second DC signal may be a signal having a potential different from that of the first DC signal described above.

Here, the second DC signal may be a signal transmitted to the sensor driving circuits SNC. For example, the second DC signal may be a reset voltage (see FIG. 5) of FIG. 5. The second DC signal may be transmitted to the first sensor driving circuit SNC1 through the second vertical connection line VL2. That is, the second vertical connection line VL2 may serve as the reset line VRL (see FIG. 5) that transmits the reset voltage VRST (see FIG. 5) of FIG. 5 through which the second DC signal is transmitted.

The second vertical connection line VL2 may be closer to the center of the first sensor driving circuit SNC1 than the second data line DL2. The second vertical connection line VL2 may be located between the second data line DL2 and the first read-out portion RX-1 in the second direction DR2 to prevent or reduce the second data line DL2 affecting the sensing signal RS (see FIG. 5) flowing through the first read-out portion RX-1. For example, even when the data voltage VD (see FIG. 5) is applied to the second data line DL2 as a pulse signal, the data voltage VD may be shielded by the second DC signal flowing through the second vertical connection line VL2 and thus may not affect the sensing signal RS (see FIG. 5) of the first read-out portion RX-1. In this way, the second vertical connection line VL2 may prevent or reduce coupling between the second data line DL2 connected to the pixel driving circuit PC and the first read-out portion RX-1 connected to the sensor driving circuit SNC.

The first read-out portion RX-1 may be located between the first vertical connection line VL1 and the second vertical connection line VL2, which are closest to each other, among the vertical connection lines VL. Accordingly, the first read-out portion RX-1 may minimize influence by the first data line DL1 and the second data line DL2 arranged outside the first vertical connection line VL1 and the second vertical connection line VL2. The first vertical connection line VL1 and the second vertical connection line VL2 may serve as shielding wiring lines.

The third vertical connection line VL3 may be located on a left side of the second read-out portion RX-2 and extend in the first direction DR1, and the fourth vertical connection line VL4 may be located on a right side of the second read-out portion RX-2 and extend in the first direction DR1. The third vertical connection line VL3 may overlap the second sensor driving circuit SNC2, and the fourth vertical connection line VL4 may overlap the second sensor driving circuit SNC2. The second read-out portion RX-2 may overlap the second sensor driving circuit SNC2.

The third vertical connection line VL3 may be located between the third data line DL3 and the second read-out portion RX-2 in the second direction DR2. The third vertical connection line VL3 may be located closer to the first read-out portion RX-1 than to the third data line DL3 on a plane (or in a plan view). A third DC signal may be transmitted to the third vertical connection line VL3. The third DC signal may be a signal having a potential different from those of the first DC signal and the second DC signal described above.

Here, the third DC signal may be a signal transmitted to the pixel driving circuits PC. For example, the third DC signal may be one of the first initialization voltage VINT (see FIG. 5), the second initialization voltage AINT (see FIG. 5), and the second driving voltage ELVSS (see FIG. 5) of FIG. 5. The third DC signal may be transmitted to the pixel driving circuits PC through the third horizontal connection line HL3 connected to the third vertical connection line VL3.

The third vertical connection line VL3 may be electrically connected to the pixel driving circuits PC to transmit the third DC signal. Because the third DC signal transmitted to the pixel driving circuits PC is transmitted to the third vertical connection line VL3, a separate vertical wiring line may not be required in the pixel driving circuits PC. For example, when the third DC signal is the second initialization voltage AINT (see FIG. 5), a separate vertical wiring line for transmitting the second initialization voltage AINT (see FIG. 5) to the pixel driving circuits PC may not be required. Accordingly, even when the resolution of the display device DD (see FIG. 1) is increased, the difficulty in integrating wiring lines may be reduced.

The third vertical connection line VL3 may be closer to a center of the second sensor driving circuit SNC2 than the third data line DL3. The third vertical connection line VL3 may be located between the third data line DL3 and the second read-out portion RX-2 in the second direction DR2 to prevent or reduce the third data line DL3 affecting the sensing signal RS (see FIG. 5) flowing through the second read-out portion RX-2. For example, even when the data voltage VD (see FIG. 5) is applied to the third data line DL3 as a pulse signal, the data voltage VD may be shielded by the third DC signal flowing through the third vertical connection line VL3 and thus may not affect the sensing signal RS (see FIG. 5) of the second read-out portion RX-2. In this way, the third vertical connection line VL3 may prevent or reduce coupling between the third data line DL3 connected to the pixel driving circuit PC and the second read-out portion RX-2 connected to the sensor driving circuit SNC.

The fourth vertical connection line VL4 may be located between the fourth data line DL4 and the second read-out portion RX-2 in the second direction DR2. The fourth vertical connection line VL4 may be located closer to the second read-out portion RX-2 than to the fourth data line DL4 on a plane (or in a plan view). A fourth DC signal may be transmitted to the fourth vertical connection line VL4. The fourth DC signal may be a signal having a potential different from those of the first DC signal, the second DC signal, and the third DC signal described above.

Here, the fourth DC signal may be a signal transmitted to the pixel driving circuits PC. For example, the fourth DC signal may be one of the first initialization voltage VINT (see FIG. 5), the second initialization voltage AINT (see FIG. 5), and the second driving voltage ELVSS (see FIG. 5) of FIG. 5. The fourth DC signal may be transmitted to the pixel driving circuits PC through the fourth horizontal connection line HL4 connected to the fourth vertical connection line VL4.

The fourth vertical connection line VL4 may be electrically connected to the pixel driving circuits PC to transmit the fourth DC signal. Because the fourth DC signal transmitted to the pixel driving circuits PC is transmitted to the fourth vertical connection line VL4, a separate vertical wiring line may not be required in the pixel driving circuits PC. For example, when the fourth DC signal is the second initialization voltage AINT (see FIG. 5), a separate vertical wiring line for transmitting the second driving voltage ELVSS (see FIG. 5) to the pixel driving circuits PC may not be required. Accordingly, even when the resolution of the display device DD (see FIG. 1) is increased, the difficulty in integrating wiring lines may be reduced.

The fourth vertical connection line VL4 may be closer to the center of the second sensor driving circuit SNC2 than the fourth data line DL4. The fourth vertical connection line VL4 may be located between the fourth data line DL4 and the second read-out portion RX-2 in the second direction DR2 to prevent or reduce the fourth data line DL4 affecting the sensing signal RS (see FIG. 5) flowing through the second read-out portion RX-2. For example, even when the data voltage VD (see FIG. 5) is applied to the fourth data line DL4 as a pulse signal, the data voltage VD may be shielded by the fourth DC signal flowing through the fourth vertical connection line VL4 and thus may not affect the sensing signal RS (see FIG. 5) of the second read-out portion RX-2. In this way, the fourth vertical connection line VL4 may prevent or reduce coupling between the fourth data line DL4 connected to the pixel driving circuit PC and the second read-out portion RX-2 connected to the sensor driving circuit SNC.

The horizontal connection lines HL may include the first horizontal connection line HL1, the second horizontal connection line HL2, the third horizontal connection line HL3, and the fourth horizontal connection line HL4. The first horizontal connection line HL1, the second horizontal connection line HL2, the third horizontal connection line HL3, and the fourth horizontal connection line HL4 may be arranged in the first direction DR1. FIG. 10 illustrates a structure in which the second horizontal connection line HL2, the third horizontal connection line HL3, the first horizontal connection line HL1, and the fourth horizontal connection line HL4 are arranged in an order thereof in the first direction DR1, but an arrangement order of the first horizontal connection line HL1, the second horizontal connection line HL2, the third horizontal connection line HL3, and the fourth horizontal connection line HL4 is not limited thereto.

The first horizontal connection line HL1 may be electrically connected to the pixel driving circuits PC and may extend in the second direction DR2. The first horizontal connection line HL1 may be connected to the first vertical connection line VL1 by the first through-hole CNT1 passing through some of the insulating layers INS1 to INS7 (see FIGS. 7A and 7B). The first horizontal connection line HL1 and the first vertical connection line VL1 may be electrically connected to each other to transmit the first DC signal. The first horizontal connection line HL1 and the first vertical connection line VL1 that are connected to each other may have a mesh shape. That is, the first vertical connection line VL1 may be provided as a plurality of first vertical connection lines VL1, the first horizontal connection line HL1 may be provided as a plurality of first horizontal connection lines HL1, and the plurality of first vertical connection lines VL1 and the plurality of first horizontal connection lines HL1 may have a mesh shape.

The first horizontal connection line HL1 may overlap the first pixel driving circuit PC1, the second pixel driving circuit PC2, the third pixel driving circuit PC3, and the fourth pixel driving circuit PC4 and the first sensor driving circuit SNC1 and the second sensor driving circuit SNC2. The first horizontal connection line HL1 and the first vertical connection line VL1 may be arranged on different layers and may be electrically connected to each other by the first through-hole CNT1. The first horizontal connection line HL1 may be electrically connected to the first vertical connection line VL1 by the first through-hole CNT1 located at an intersection point between the first vertical connection line VL1 and the first horizontal connection line HL1. The first through-hole CNT1 may overlap the first sensor driving circuit SNC1. Here, the first through-hole CNT1 may be the same as the first through-hole CNT1 (see FIG. 7A) of FIG. 7A.

The second horizontal connection line HL2 may extend in the second direction DR2. The second horizontal connection line HL2 may be connected to the second vertical connection line VL2 by the second through-hole CNT2 passing through some of the insulating layers INS1 to INS7 (see FIGS. 7A and 7B). The second horizontal connection line HL2 and the second vertical connection line VL2 may be electrically connected to each other to transmit the second DC signal. The second horizontal connection line HL2 and the second vertical connection line VL2 that are connected to each other may have a mesh shape. That is, the second vertical connection line VL2 may be provided as a plurality of second vertical connection lines VL2, the second horizontal connection line HL2 may be provided as a plurality of second horizontal connection lines HL2, and the plurality of second vertical connection lines VL2 and the plurality of second horizontal connection lines HL2 may have a mesh shape.

The second horizontal connection line HL2 may overlap the first pixel driving circuit PC1, the second pixel driving circuit PC2, the third pixel driving circuit PC3, and the fourth pixel driving circuit PC4 and the first sensor driving circuit SNC1 and the second sensor driving circuit SNC2. The second horizontal connection line HL2 and the second vertical connection line VL2 may be arranged on different layers and may be electrically connected to each other by the second through-hole CNT2. The second horizontal connection line HL2 may be electrically connected to the second vertical connection line VL2 by the second through-hole CNT2 located at an intersection point between the second vertical connection line VL2 and the second horizontal connection line HL2. The second through-hole CNT2 may overlap the first sensor driving circuit SNC1. Here, the second through-hole CNT2 may be the same as the second through-hole CNT2 (see FIG. 7A) of FIG. 7A.

The third horizontal connection line HL3 may be electrically connected to the pixel driving circuits PC and may extend in the second direction DR2. The third horizontal connection line HL3 may be connected to the third vertical connection line VL3 by the third through-hole CNT3 passing through some of the insulating layers INS1 to INS7 (see FIGS. 7A and 7B). The third horizontal connection line HL3 and the third vertical connection line VL3 may be electrically connected to each other to transmit the third DC signal. The third horizontal connection line HL3 and the third vertical connection line VL3 that are connected to each other may have a mesh shape. That is, the third vertical connection line VL3 may be provided as a plurality of third vertical connection lines VL3, the third horizontal connection line HL3 may be provided as a plurality of third horizontal connection lines HL3, and the plurality of third vertical connection lines VL3 and the plurality of third horizontal connection lines HL3 may have a mesh shape.

The third horizontal connection line HL3 may overlap the first pixel driving circuit PC1, the second pixel driving circuit PC2, the third pixel driving circuit PC3, and the fourth pixel driving circuit PC4 and the first sensor driving circuit SNC1 and the second sensor driving circuit SNC2. The third horizontal connection line HL3 and the third vertical connection line VL3 may be arranged on different layers and may be electrically connected to each other by the third through-hole CNT3. The third horizontal connection line HL3 may be electrically connected to the third vertical connection line VL3 by the third through-hole CNT3 located at an intersection point between the third vertical connection line VL3 and the third horizontal connection line HL3. The third through-hole CNT3 may overlap the second sensor driving circuit SNC2. Here, the third through-hole CNT3 may be the same as the third through-hole CNT3 (see FIG. 7A) of FIG. 7B.

The fourth horizontal connection line HL4 may be electrically connected to the pixel driving circuits PC and may extend in the second direction DR2. The fourth horizontal connection line HL4 may be connected to the fourth vertical connection line VL4 by the fourth through-hole CNT4 passing through some of the insulating layers INS1 to INS7 (see FIGS. 7A and 7B). The fourth horizontal connection line HL4 and the fourth vertical connection line VL4 may be electrically connected to each other to transmit the fourth DC signal. The fourth horizontal connection line HL4 and the fourth vertical connection line VL4 that are connected to each other may have a mesh shape. That is, the fourth vertical connection line VL4 may be provided as a plurality of fourth vertical connection lines VL4, the fourth horizontal connection line HL4 may be provided as a plurality of fourth connection lines HL4, and the plurality of fourth vertical connection lines VL4 and the plurality of fourth horizontal connection lines HL4 may have a mesh shape.

The fourth horizontal connection line HL4 may overlap the first pixel driving circuit PC1, the second pixel driving circuit PC2, the third pixel driving circuit PC3, and the fourth pixel driving circuit PC4 and the first sensor driving circuit SNC1 and the second sensor driving circuit SNC2. The fourth horizontal connection line HL4 and the fourth vertical connection line VL4 may be arranged on different layers and may be electrically connected to each other by the fourth through-hole CNT4. The fourth horizontal connection line HL4 may be electrically connected to the fourth vertical connection line VL4 by the fourth through-hole CNT4 located at an intersection point between the fourth vertical connection line VL4 and the fourth horizontal connection line HL4. The fourth through-hole CNT4 may overlap the second sensor driving circuit SNC2. Here, the fourth through-hole CNT4 may be the same as the fourth through-hole CNT4 (see FIG. 7A) of FIG. 7B.

The arrangement of the first contact hole CH1, the second contact hole CH2, the third contact hole CH3, and the fourth contact hole CH4, the first vertical connection line VL1, the second vertical connection line VL2, the third vertical connection line VL3, and the fourth vertical connection line VL4, and the first horizontal connection line HL1, the second horizontal connection line HL2, the third horizontal connection line HL3, and the fourth horizontal connection line HL4 illustrated in FIG. 10 is not limited to the arrangement structure illustrated in FIG. 10.

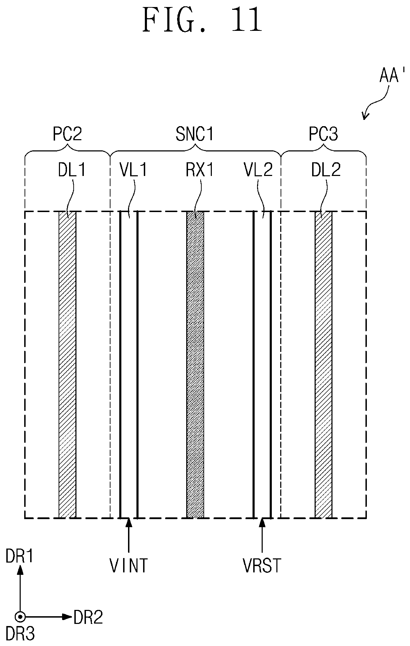

FIG. 11 is an enlarged plan view of an area AA' of FIG. 10.

Referring to FIG. 11, the first vertical connection line VL1 may be located closer to the first read-out portion RX-1 than to the first data line DL1 on a plane (or in a plan view). The second vertical connection line VL2 may be located closer to the first read-out portion RX-1 than to the second data line DL2 on a plane (or in a plan view). The first vertical connection line VL1 and the second vertical connection line VL2 may surround the first read-out portion RX-1 on a plane (or in a plan view).

Because the DC signal flows through the first vertical connection line VL1 and the second vertical connection line VL2, it is possible to prevent or reduce the first read-out portion RX-1 being affected by the first data line DL1 and the second data line DL2. The first vertical connection line VL1 may prevent or reduce a data signal transmitted to the first data line DL1 located on the left side of the first read-out portion RX-1 affecting the sensing signal transmitted to the first read-out portion RX-1. The second vertical connection line VL2 may prevent or reduce a data signal transmitted to the second data line DL2 located on the right side of the first read-out portion RX-1 affecting the sensing signal transmitted to the first read-out portion RX-1.

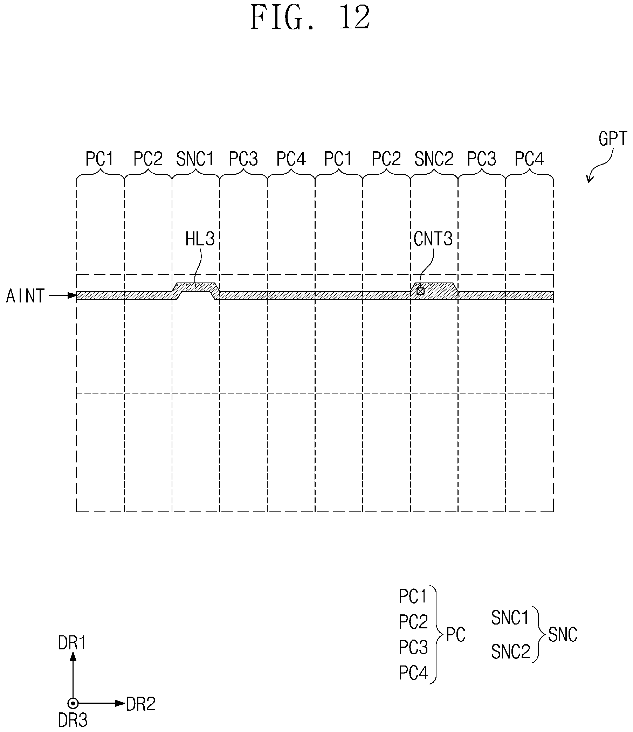

FIGS. 12 to 15 are plan views illustrating laminated structures of the data lines, the vertical connection lines, and the horizontal connection lines according to some embodiments of the present disclosure.

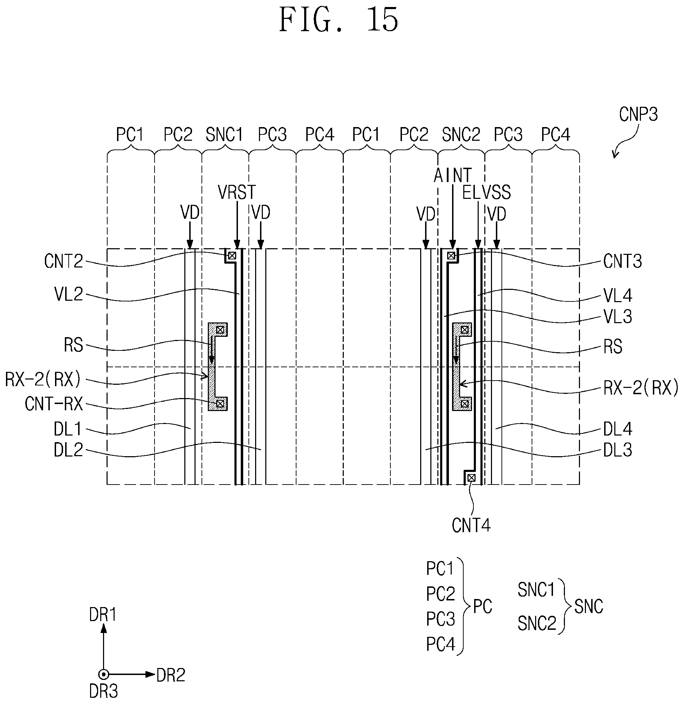

FIG. 12 illustrates the third horizontal connection line HL3 located on a third gate layer GPT on the fourth insulating layer INS4 (see FIGS. 7A and 7B). That is, the third horizontal connection line HL3 illustrated in FIG. 12 may be located at the same layer as the second gate electrode G2' (refer to FIG. 7B) of FIG. 7B and formed through the same process. The third horizontal connection line HL3 may extend in the second direction DR2 and may be connected to the third vertical connection line VL3 (see FIG. 15) by the third through-hole CNT3. The third through-hole CNT3 may overlap the second sensor driving circuit SNC2.

The third horizontal connection line HL3 may be electrically connected to the first pixel driving circuit PC1, the second pixel driving circuit PC2, the third pixel driving circuit PC3, and the fourth pixel driving circuit PC4. The second initialization voltage AINT may be applied to the third horizontal connection line HL3. The second initialization voltage AINT applied to the third horizontal connection line HL3 may be transmitted to the third vertical connection line VL3 and the first pixel driving circuit PC1, the second pixel driving circuit PC2, the third pixel driving circuit PC3, and the fourth pixel driving circuit PC4.

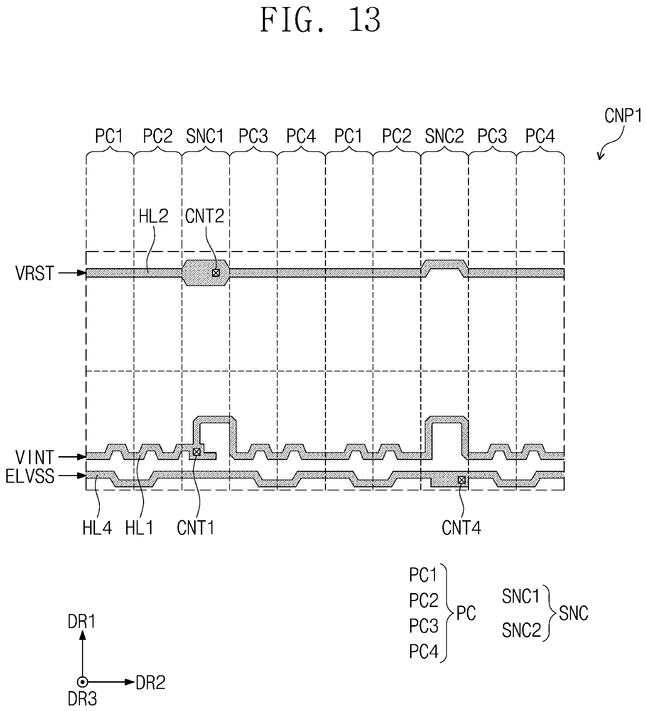

FIG. 13 illustrates the first horizontal connection line HL1, the second horizontal connection line HL2, and the fourth horizontal connection line HL4 arranged in a first group conductive pattern CNP1 on the fifth insulating layer INS5 (see FIGS. 7A and 7B). That is, the first horizontal connection line HL1, the second horizontal connection line HL2, and the fourth horizontal connection line HL4 illustrated in FIG. 13 may be arranged at the same layer as the first connection electrode CNE1' (see FIGS. 7A and 7B) of FIGS. 7A and 7B and formed through the same process. The first horizontal connection line HL1, the second horizontal connection line HL2, and the fourth horizontal connection line HL4 may not overlap each other on a plane (or in a plan view).

The first horizontal connection line HL1, the second horizontal connection line HL2, and the fourth horizontal connection line HL4 may extend in the second direction DR2. Each of the first horizontal connection line HL1 and the fourth horizontal connection lines HL4 may be electrically connected to the first pixel driving circuit PC1, the second pixel driving circuit PC2, the third pixel driving circuit PC3, and the fourth pixel driving circuit PC4. The second horizontal connection line HL2 may be electrically connected to the sensor driving circuit SNC.

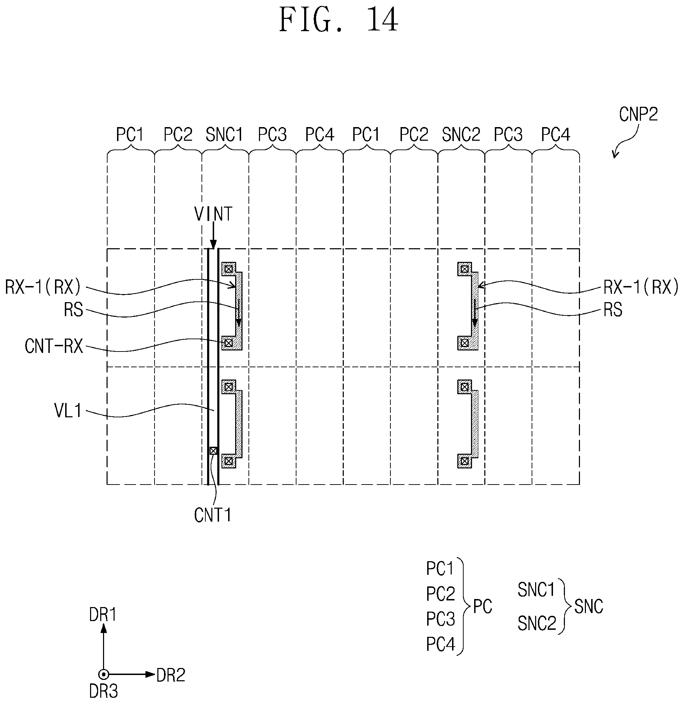

The first horizontal connection line HL1 may be connected to the first vertical connection line VL1 (see FIG. 14) by the first through-hole CNT1. The first through-hole CNT1 may overlap the first sensor driving circuit SNC1. The first initialization voltage VINT may be applied to the first horizontal connection line HL1. The first initialization voltage VINT applied to the first horizontal connection line HL1 may be transmitted to the first vertical connection line VL1 (see FIG. 14) and the first pixel driving circuit PC1, the second pixel driving circuit PC2, the third pixel driving circuit PC3, and the fourth pixel driving circuit PC4.

The second horizontal connection line HL2 may be connected to the second vertical connection line VL2 (see FIG. 15) by the second through-hole CNT2. The second through-hole CNT2 may overlap the first sensor driving circuit SNC1. The reset voltage VRST may be applied to the second horizontal connection line HL2. The reset voltage VRST applied to the second horizontal connection line HL2 may be transmitted to the second vertical connection line VL2 and the first sensor driving circuit SNC1.

The fourth horizontal connection line HL4 may be connected to the fourth vertical connection line VL4 (see FIG. 15) by the fourth through-hole CNT4. The fourth through-hole CNT4 may overlap the second sensor driving circuit SNC2. The second driving voltage ELVSS may be applied to the fourth horizontal connection line HL4. The second driving voltage ELVSS applied to the fourth horizontal connection line HL4 may be transmitted to the fourth vertical connection line VL4 (see FIG. 15) and the second sensor driving circuit SNC2.

FIG. 14 illustrates the first vertical connection line VL1 and the first read-out portion RX-1 arranged in a second group conductive pattern CNP2 on the sixth insulating layer INS6 (see FIG. 7A). That is, the first vertical connection line VL1 and the first read-out portion RX-1 illustrated in FIG. 14 may be arranged at the same layer as the second connection electrode CNE2' of FIG. 7A and may be formed through the same process. The first vertical connection line VL1 and the first read-out portion RX-1 may not overlap each other on a plane (or in a plan view).

The first vertical connection line VL1 and the first read-out portion RX-1 may extend in the first direction DR1. The first vertical connection line VL1 may be electrically connected to the first horizontal connection line HL1 (see FIG. 13) and the first pixel driving circuit PC1, the second pixel driving circuit PC2, the third pixel driving circuit PC3, and the fourth pixel driving circuit PC4.

The first vertical connection line VL1 may be connected to the first horizontal connection line HL1 (see FIG. 13) by the first through-hole CNT1. The first through-hole CNT1 may overlap the first sensor driving circuit SNC1. The first initialization voltage VINT may be transmitted to the first vertical connection line VL1. As described above, the first initialization voltage VINT applied to the first horizontal connection line HL1 may be transmitted to the first vertical connection line VL1 and the first pixel driving circuit PC1, the second pixel driving circuit PC2, the third pixel driving circuit PC3, and the fourth pixel driving circuit PC4.

The first read-out portion RX-1 may be connected to the second read-out portion RX-2 (see FIG. 15) by the through-hole CNT-RX. The through-hole CNT-RX may overlap the sensor driving circuit SNC. The sensing signal RS may be transmitted to the first read-out portion RX-1. The first read-out portion RX-1 and the second read-out portion RX-2 (see FIG. 15) may be electrically connected to the sensor driving circuit SNC.

FIG. 15 illustrates the first data line DL1, the second data line DL2, the third data line DL3, and the fourth data line DL4, the second read-out portion RX-2, and the second vertical connection line VL2, the third vertical connection line VL3, and the fourth vertical connection line VL4 arranged in a third group conductive pattern CNP3 on the seventh insulating layer INS7 (see FIGS. 7A and 7B). That is, the first data line DL1, the second data line DL2, the third data line DL3, and the fourth data line DL4, the second read-out portion RX-2, and the second vertical connection line VL2, the third vertical connection line VL3, and the fourth vertical connection line VL4 illustrated in FIG. 15 may be arranged at the same layer as the third connection electrode CNE3' (see FIGS. 7A and 7B) of FIGS. 7A and 7B and may be formed through the same process. The first data line DL1, the second data line DL2, the third data line DL3, and the fourth data line DL4, the second read-out portion RX-2, and the second vertical connection line VL2, the third vertical connection line VL3, and the fourth vertical connection line VL4 may not overlap each other on a plane (or in a plan view).

The first data line DL1 may overlap the second pixel driving circuit PC2, may be electrically connected to the second pixel driving circuit PC2, and may extend in the first direction DR1. The second data line DL2 may overlap the third pixel driving circuit PC3, may be electrically connected to the third pixel driving circuit PC3, and may extend in the first direction DR1. The third data line DL3 may overlap the second pixel driving circuit PC2, may be electrically connected to the second pixel driving circuit PC2, and may extend in the first direction DR1. The fourth data line DL4 may overlap the third pixel driving circuit PC3, may be electrically connected to the third pixel driving circuit PC3, and may extend in the first direction DR1. The data voltage VD required for the pixel driving circuits PC2 and PC3 may be applied to the first data line DL1, the second data line DL2, the third data line DL3, and the fourth data line DL4.

The second read-out portion RX-2 may be electrically connected to the first read-out portion RX-1 (see FIG. 14) by the through-hole CNT-RX. The sensing signal RS may be transmitted to the second read-out portion RX-2. The first read-out portion RX-1 and the second read-out portion RX-2 (see FIGS. 14 and 15) may form the read-out line RX.

The second vertical connection line VL2 may be connected to the second horizontal connection line HL2 (see FIG. 13) by the second through-hole CNT2. The second through-hole CNT2 may overlap the first sensor driving circuit SNC1. The reset voltage VRST may be applied to the second vertical connection line VL2. The second vertical connection line VL2 may be electrically connected to the first sensor driving circuit SNC1 to provide the reset voltage VRST to the first sensor driving circuit SNC1.

The third vertical connection line VL3 may be connected to the third horizontal connection line HL3 (see FIG. 12) by the third through-hole CNT3. The third through-hole CNT3 may overlap the second sensor driving circuit SNC2. The second initialization voltage AINT may be transmitted to the third vertical connection line VL3. As described above, the second initialization voltage AINT applied to the third horizontal connection line HL3 (see FIG. 12) may be transmitted to the third vertical connection line VL3 and the first pixel driving circuit PC1, the second pixel driving circuit PC2, the third pixel driving circuit PC3, and the fourth pixel driving circuit PC4.

The fourth vertical connection line VL4 may be connected to the fourth horizontal connection line HL4 (see FIG. 13) by the fourth through-hole CNT4. The fourth through-hole CNT4 may overlap the second sensor driving circuit SNC2. The second driving voltage ELVSS may be transmitted to the fourth vertical connection line VL4. As described above, the second driving voltage ELVSS applied to the fourth horizontal connection line HL4 (see FIG. 13) may be transmitted to the fourth vertical connection line VL4 and the first pixel driving circuit PC1, the second pixel driving circuit PC2, the third pixel driving circuit PC3, and the fourth pixel driving circuit PC4.

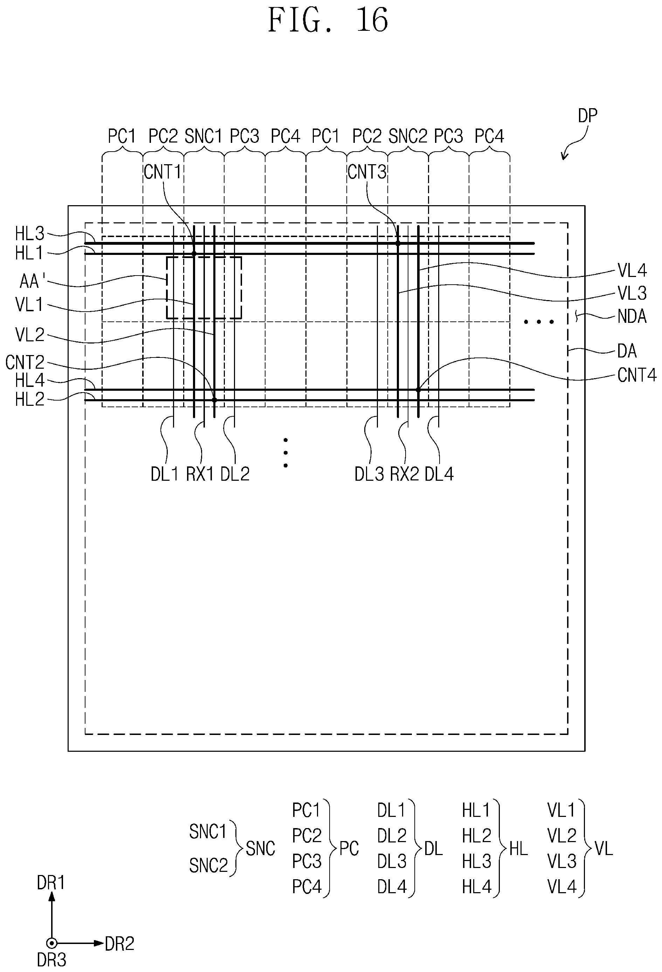

FIG. 16 is a plan view illustrating the data lines DL, the vertical connection lines VL, and the horizontal connection lines HL according to some embodiments of the present disclosure. In FIG. 16, only the arrangement of the vertical connection line VL (see FIG. 10) and the horizontal connection line HL (see FIG. 10) of FIG. 10 is changed, and the other configurations are the same, and thus description of the same configurations will be omitted.

Referring to FIG. 16, the horizontal connection lines HL may include the first horizontal connection line HL1, the second horizontal connection line HL2, the third horizontal connection line HL3, and the fourth horizontal connection line HL4. The first horizontal connection line HL1, the second horizontal connection line HL2, the third horizontal connection line HL3, and the fourth horizontal connection line HL4 may be arranged in the first direction DR1. According to FIG. 16, the first horizontal connection line HL1, the second horizontal connection line HL2, the third horizontal connection line HL3, and the fourth horizontal connection line HL4 may be arranged in an order of the third horizontal connection line HL3, the first horizontal connection line HL1, the fourth horizontal connection line HL4, and the second horizontal connection line HL2 in a direction opposite to the first direction DR1 in the display area DA.

The first vertical connection line VL1 and the first horizontal connection line HL1 may be electrically connected by the first through-hole CNT1. The first through-hole CNT1 may overlap the first sensor driving circuit SNC1. The second vertical connection line VL2 and the second horizontal connection line HL2 may be electrically connected by the second through-hole CNT2. The second through-hole CNT2 may overlap the first sensor driving circuit SNC1. The third vertical connection line VL3 and the third horizontal connection line HL3 may be electrically connected by the third through-hole CNT3. The third through-hole CNT3 may overlap the second sensor driving circuit SNC2. The fourth vertical connection line VL4 and the fourth horizontal connection line HL4 may be electrically connected by the fourth through-hole CNT4. The fourth through-hole CNT4 may overlap the second sensor driving circuit SNC2.

In a display device according to the present disclosure, a vertical connection line to which a direct current (DC) signal is applied may be located between a data line and a read-out line and thus serves as a shielding wiring line and prevents or reduces a signal of the data line affecting the read-out line.

Further, a signal transmitted to a pixel driving circuit may be applied to a mesh-shaped connection line including a vertical connection line and a horizontal connection line, a separate wiring line may be omitted in the pixel driving circuit, and thus difficulty of integration may be reduced.

Although the description has been made above with reference to aspects of some embodiments of the present disclosure, it may be understood that those skilled in the art or those having ordinary knowledge in the art may variously modify and change the present disclosure without departing from the technical scope of the present disclosure described in the appended claims. Accordingly, the technical scope of embodiments according to the present disclosure is not limited to the detailed description of the specification, but should be defined by the appended claims, and their equivalents.

## Claims

1. A display device comprising:
a base layer (SUB) on which a display area and a non-display area are defined;
a circuit element layer (DP-CL) on the base layer; and
a display element layer (DP-OLED) disposed on the circuit element layer and including a light emitting element and a light receiving element overlapping the display area,
wherein the circuit element layer (DP-CL) includes:
pixel driving circuits (PC) connected to the light emitting element;
sensor driving circuits (SNC) connected to the light receiving element;
a read-out line (RX) connected to the sensor driving circuits and extending in a first direction;
a first data line (DL1) connected to the pixel driving circuits and extending in the first direction;
a first vertical connection line (VL1) between the first data line and the read-out line in a second direction intersecting the first direction and extending in the first direction and configured to receive a first direct current, DC, signal; and
an insulating layer configured to cover the first vertical connection line (VL1) and the first data line, and
wherein the first DC signal is a signal transmitted to the pixel driving circuits.

2. The display device of claim 1, wherein the circuit element layer (DP-CL) further includes:
a first horizontal connection line (HL1) electrically connected to the pixel driving circuits (PC), extending in the second direction, and connected to the first vertical connection line (VL1) by a first through-hole passing through the insulating layer, and configured to receive the first DC signal.

3. The display device of claim 2, wherein the first vertical connection line (VL1) and the first horizontal connection line (HL1) are on different layers.

4. The display device of claim 2 or 3, wherein the first vertical connection line (VL1) is provided in plurality,
wherein the first horizontal connection line (HL1) is provided in plurality, and
wherein the plurality of first vertical connection lines (VL1) and the plurality of first horizontal connection lines (HL1) have a mesh shape.

5. The display device of any of claims 2 to **4,** wherein the read-out line (RX) is between two first vertical connection lines (VL1) that are closest to each other among the plurality of first vertical connection lines.

6. The display device of any of the preceding claims, wherein the circuit element layer (DP-CL) further includes:
a second data line (DL2) connected to the pixel driving circuits, spaced apart from the first data line, and extending in the first direction; and
a second vertical connection line (VL2) between the second data line and the read-out line in the second direction and extending in the first direction and configured to receive a second DC signal.

7. The display device of claim 6, wherein the second DC signal is a signal transmitted to the sensor driving circuits (DL2).

8. The display device of claim 6 or 7, wherein the circuit element layer (DP-CL) further includes:
a second horizontal connection line (HL2) extending in the second direction and connected to the second vertical connection line by a second through-hole passing through the insulating layer and configured to receive the second DC signal.

9. The display device of claim 8, wherein the second vertical connection line (VL2) and the second horizontal connection line (HL2) are on different layers.

10. The display device of claim 8 or 9, wherein the second vertical connection line (VL2) is provided in plurality,
wherein the second horizontal connection line (HL2) is provided in plurality, and
wherein the plurality of second vertical connection lines and the plurality of second horizontal connection lines have a mesh shape.

11. The display device of any of claims 8 to 10, wherein the read-out line (RX) is between the first vertical connection line (VL1) and the second vertical connection line (VL2).

12. The display device of any of the preceding claims, wherein each of the sensor driving circuits (SNC) is between each of two corresponding pixel driving circuits (PC) among the pixel driving circuits (PC), and/or wherein the first vertical connection line (VL1) overlaps one of the sensor driving circuits (SNC).

13. The display device of any of claims 6 to 12, wherein the second vertical connection line (VL2) overlaps the sensor driving circuits (SNC).

14. The display device of any of the preceding claims, wherein the first vertical connection line (VL1) is closer to a center of one of the sensor driving circuits than the first data line (DL1), and/or wherein the first vertical connection line (VL1) is electrically connected to the pixel driving circuits.

15. An electronic device comprising the display device of any of the preceding claims, wherein the display device further comprises a window (WIN) disposed on the display element layer (DP-OLED).
